# EUROPEAN PATENT APPLICATION

(11) **EP 4 800 155 A1**
(43) Date of publication of application: **02.09.2026**
(21) Application number: 26161388.9
(22) Date of filing: 27.02.2026
(51) Int. Cl.: C23C 28/04, C23C 30/00, C23C 16/02, C23C 16/30, C23C 16/32, C23C 16/34, C23C 16/36, C23C 16/38, C23C 16/40

(54) **COATED CUTTING TOOL**

(30) Priority: 28.02.2025 JP 2025031084
(71) Applicant: Tungaloy Corporation, Iwaki-shi, Fukushima 970-1144 (JP)
(72) Inventor: FAN, Cangyu, Iwaki-shi, Fukushima, 9701144 (JP); SHIROCHI, Tsukasa, Iwaki-shi, Fukushima, 9701144 (JP); TAKAHASHI, Kinya, Iwaki-shi, Fukushima, 9701144 (JP)
(74) Representative: Vossius & Partner Patentanwälte Rechtsanwälte mbB

(57) **Abstract**

Provided is a coated cutting tool which has excellent wear resistance and fracture resistance and which accordingly allows for an extended tool life. A coated cutting tool including a substrate and a coating layer formed on a surface of the substrate, wherein: the coating layer includes a lower layer including a specific compound layer, an intermediate layer including an α-Al₂O₃ layer, and an upper layer in this order from the substrate side to the surface side of the coating layer; the upper layer includes one or more Ti compound layers containing a specific compound; the upper layer includes at least one TiCN layer containing TiCN; the lower layer, the intermediate layer and the upper layer have a specific average thickness; in a cross section of the TiCN layer of the upper layer parallel to the surface of the substrate, when a sum of areas of an entire cross section is taken as 100 area%, a ratio of a sum of cross-sectional areas of specific regions A is 30 area% or more and 70 area% or less; and in the region A, a ratio of the total length of Σ3 grain boundaries to 100% of the total grain boundary length, is 30% or more and less than 60%.

## Description

### BACKGROUND OF THE INVENTION

### Field of the Invention

The present invention relates to a coated cutting tool.

### Description of the Related Art

It is well known that a conventional coated cutting tool used for the cutting of steel, cast iron, etc., is a coated cutting tool which is obtained by depositing, via chemical vapor deposition, a coating layer with a total thickness of from 3 µm or more to 20 µm or less on a surface of a substrate consisting of a cemented carbide. A known example of the above coating layer is a coating layer consisting of a single layer of one kind selected from the group consisting of a Ti carbide, a Ti nitride, a Ti carbonitride, a Ti carboxide, a Ti oxycarbonitride, and aluminum oxide (Al₂O₃), or consisting of multiple layers of two or more kinds selected therefrom.

For example, Japanese Patent Laid-Open No. 2024-082049 discloses a coated cutting tool comprising a substrate and a coating layer formed on a surface of the substrate. The coating layer comprises a lower layer, an intermediate layer, and an upper layer in this order from the substrate side to the surface side of the coating layer. The lower layer comprises one or more Ti compound layers containing a Ti compound formed of Ti and an element of at least one kind selected from the group consisting of C, N, O, and B. The intermediate layer comprises an α-Al₂O₃ layer composed of α-Al₂O₃. The upper layer comprises one or more Ti compound layers containing a Ti compound of Ti and an element of at least one kind selected from the group consisting of C, N, and O. At least one of the Ti compound layers in the upper layer is a TiCN layer. The average thickness of the upper layer is 1.00 µm or more and 6.50 µm or less. In a cross section of the upper layer in a direction perpendicular to the surface of the substrate, when a sum of areas of an entire cross section is taken as 100 area %, a ratio (RSA1) of a cross-sectional area of a region where a misorientation A is 0 degrees or more and less than 10 degrees, the misorientation A being an angle, in terms of degrees, formed by a normal to a (220) plane of each grain having a cubic crystalline structure and a normal to the surface of the substrate, satisfies predetermined conditions. In a cross section of the upper layer in a direction perpendicular to the surface of the substrate, when a sum of areas of an entire cross section is taken as 100 area %, a ratio (RSA2) of a cross-sectional area of a region where a misorientation A is 20 degrees or more and less than 30 degrees, the misorientation A being an angle, in terms of degrees, formed by a normal to a (220) plane of each grain having a cubic crystalline structure and a normal to the surface of the substrate, satisfies predetermined conditions.

Furthermore, for example, Japanese Translation of PCT International Application Publication No. 2017-530019 discloses a coated cutting tool comprising a substrate made of cemented carbide, cermet, ceramic, steel, or cubic boron nitride, and a multilayer wear-resistant coating having a total coating thickness of 5 to 25 µm and including at least two refractory coating layers deposited by chemical vapor deposition (CVD) or medium-temperature chemical vapor deposition (MT-CVD). The at least two refractory coating layers include a first coating layer and a second coating layer deposited one on top of the other. The first coating layer is composed of titanium aluminum nitride or titanium aluminum carbonitride represented by Ti₁₋ᵤAlᵤCᵥN_{w} (0.2 ≤ u ≤ 1.0, 0 ≤ v ≤0.25, and 0.7 ≤ w ≤ 1.15) and is deposited by CVD at a reaction temperature of 600°C to 900°C. The second coating layer is composed of titanium carbonitride represented by TiₓC_{y}N_{1-γ} (0.85 ≤ x ≤ 1.1 and 0.4 ≤ γ ≤ 0.85) and is deposited by MT-CVD at a reaction temperature of 600°C to 900°C on the first coating layer. The second TiₓC_{y}N_{1-γ} coating layer has a columnar grain morphology, and the overall fiber texture of the TiₓC_{y}N_{1-γ} coating layer has a specified texture coefficient TC(111) > 2.

An increase in speed, feed and depth of cut has become more conspicuous in cutting in recent times, and the wear resistance and the fracture resistance of a tool are required to be further improved compared to those involved in the prior art. In high-speed cutting of steel, in particular, crater wear tends to progress rapidly, which makes it difficult to achieve a long tool life. In addition, during machining involving mechanical and thermal shocks, fracture occurs due to particle detachment, resulting in a shortened tool life. The coated cutting tool disclosed in Japanese Translation of PCT International Application Publication No. 2017-530019 does not include an α-Al₂O₃ layer, and therefore, in machining where crater wear easily progresses, the wear resistance is insufficient. Moreover, because the proportion of Σ3 grain boundaries in the TiCN layer is small, crater-wear resistance is inadequate, leaving room for improvement in wear resistance.

The present invention has been made in light of the above circumstances, and an object of the present invention is to provide a coated cutting tool which has excellent wear resistance, chipping resistance and fracture resistance and which accordingly allows for an extended tool life.

### SUMMARY OF THE INVENTION

The inventors of the present invention have conducted research on extending the tool life of a coated cutting tool from the above perspective. It has been found that, with a specific configuration, the wear resistance and the fracture resistance can be improved, and as a result, the tool life can be extended. The present invention has been accomplished based on this finding.

Thus, the present invention is as follows.
<1> A coated cutting tool comprising a substrate and a coating layer formed on a surface of the substrate, wherein:
   the coating layer comprises a lower layer, an intermediate layer, and an upper layer in this order from the substrate side to the surface side of the coating layer;
   the lower layer comprises one or more Ti compound layers containing a Ti compound of Ti and an element of at least one kind selected from the group consisting of C, N, O and B;
   an average thickness of the lower layer is 3.0 µm or more and 15.0 µm or less;
   the intermediate layer comprises an α-Al₂O₃ layer containing α-aluminum oxide;
   an average thickness of the intermediate layer is 3.0 µm or more and 15.0 µm or less;
   the upper layer comprises one or more Ti compound layers containing a Ti compound of Ti and an element of at least one kind selected from the group consisting of C, N, O and B;
   the upper layer comprises at least one TiCN layer containing TiCN;
   an average thickness of the upper layer is 1.0 µm or more and 6.0 µm or less; and
   in a cross section of the TiCN layer of the upper layer in a direction parallel to the surface of the substrate, when a sum of areas of an entire cross section is taken as 100 area%, a ratio of a sum of cross-sectional areas of regions A where a misorientation is 0 degrees or more and less than 15 degrees, the misorientation being an angle formed by a normal to the cross section of the TiCN layer of the upper layer and a normal to a (220) plane of grains of the TiCN layer, is 30 area% or more and 70 area% or less; and
   in the region A, a ratio of the total length of Σ3 grain boundaries to 100% of the total grain boundary length, is 30% or more and less than 60%.
<2> The coated cutting tool according to <1>, wherein the ratio of the total length of Σ3 grain boundaries to 100% of the total grain boundary length in the entire cross section of the TiCN layer in the upper layer is less than 30%.
<3> The coated cutting tool according to <1> or <2>, wherein the surface of the intermediate layer has a mean spacing of profile irregularities RSm of 5 µm or more and 20 µm or less.
<4> The coated cutting tool according to any one of <1> to <3>, wherein the average thickness of the entire coating layer is 10.0 µm or more and 30.0 µm or less.

According to the present invention, a coated cutting tool which has excellent wear resistance and fracture resistance and which accordingly allows for an extended tool life can be provided.

### BRIEF DESCRIPTION OF THE DRAWING

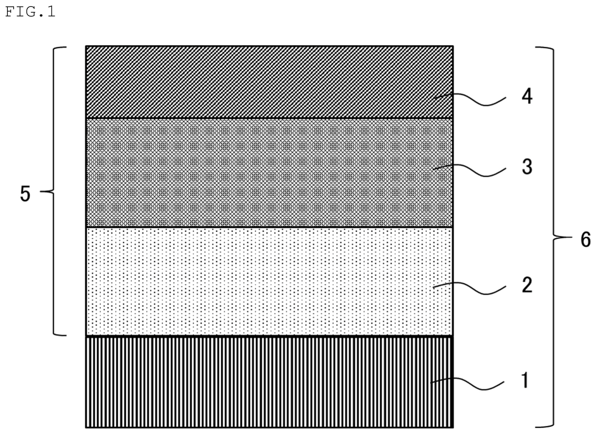

FIG. 1 is a schematic cross-sectional view showing an example of a coated cutting tool according to the present invention.

### DETAILED DESCRIPTION OF THE INVENTION

An embodiment for carrying out the present invention (hereinafter simply referred to as the "present embodiment") will hereinafter be described in detail, with reference to the attached drawings as appropriate. However, the present invention is not limited to the present embodiment below. Various modifications may be made to the present invention without departing from the gist of the invention. In the drawings, unless otherwise specified, positional relationships, such as vertical and horizontal relationships, are based on the positional relationships shown in the drawings. Further, the dimensional ratios of the drawings are not limited to those shown therein.

The coated cutting tool of the present embodiment comprises a substrate and a coating layer formed on a surface of the substrate, wherein: the coating layer comprises a lower layer, an intermediate layer, and an upper layer in this order from the substrate side to the surface side of the coating layer; the lower layer comprises one or more Ti compound layers containing a Ti compound of Ti and an element of at least one kind selected from the group consisting of C, N, O and B; the average thickness of the lower layer is 3.0 µm or more and 15.0 µm or less; the intermediate layer comprises an α-Al₂O₃ layer containing α-aluminum oxide; the average thickness of the intermediate layer is 3.0 µm or more and 15.0 µm or less; the upper layer comprises one or more Ti compound layers containing a Ti compound of Ti and an element of at least one kind selected from the group consisting of C, N, O and B; the upper layer comprises at least one TiCN layer containing TiCN; the average thickness of the upper layer is 1.0 µm or more and 6.0 µm or less; and in a cross section of the TiCN layer of the upper layer in a direction parallel to the surface of the substrate, when a sum of areas of an entire cross section is taken as 100 area%, a ratio of a sum of cross-sectional areas (hereinafter also referred to as "RSA"),of regions A where a misorientation is 0 degrees or more and less than 15 degrees, the misorientation (hereinafter also referred to as "misorientation A"), being an angle formed by a normal to the cross section of the TiCN layer of the upper layer and a normal to a (220) plane of grains of the TiCN layer, is 30 area% or more and 70 area% or less; and in the region A, a ratio of the total length of Σ3 grain boundaries to 100% of the total grain boundary length, is 30% or more and less than 60%.

The coated cutting tool of the present embodiment comprises the above-described configurations, and this allows the wear resistance and the fracture resistance of the coated cutting tool to be improved; as a result, the tool life thereof can be extended. The factors for the improvements in wear resistance and fracture resistance of the coated cutting tool of the present embodiment can be considered to be set forth as follows. However, the present invention is not in any way limited by the factors set forth below. That is, in the coated cutting tool of the present embodiment, since the average thickness of the lower layer is 3.0 µm or more, flank wear is suppressed and thus wear resistance is improved. On the other hand, in the coated cutting tool of the present embodiment, since the average thickness of the lower layer is 15.0 µm or less, peeling of the coating layer is suppressed and thus fracture resistance is improved. In addition, in the coated cutting tool of the present embodiment, since the average thickness of the intermediate layer is 3.0 µm or more, crater wear is suppressed and thus wear resistance is improved. On the other hand, in the coated cutting tool of the present embodiment, since the average thickness of the intermediate layer is 15.0 µm or less, peeling of the coating layer is suppressed and thus fracture resistance is improved. Furthermore, in the coated cutting tool of the present embodiment, since the average thickness of the upper layer is 1.0 µm or more, flank wear is suppressed and thus wear resistance is improved. On the other hand, in the coated cutting tool of the present embodiment, since the average thickness of the upper layer is 6.0 µm or less, peeling of the coating layer is suppressed and thus fracture resistance is improved. In addition, since the upper layer of the coated cutting tool of the present embodiment includes, on the outer side of the α-Al₂O₃ layer, a TiCN layer in which the RSA and the ratio of the total length of Σ3 grain boundaries to 100% of the total grain boundary length in the region A are controlled as described above, both wear resistance and fracture resistance are enhanced. Furthermore, in the coated cutting tool of the present embodiment, since the RSA is 30 area% or more, detachment of particles caused by mechanical and thermal shocks is suppressed, improving fracture resistance. On the other hand, in the coated cutting tool of the present embodiment, since the RSA is 70 area% or less, wear resistance is improved. Moreover, in the coated cutting tool of the present embodiment, since the ratio of the total length of Σ3 grain boundaries to 100% of the total grain boundary length in the region A is 30% or more, the effect of suppressing particle detachment achieved by an RSA of 30 area% or more is further enhanced, thereby improving fracture resistance. In addition, since mechanical properties are improved, crater wear is suppressed and wear resistance is also improved. On the other hand, in the coated cutting tool of the present embodiment, since the ratio of the total length of Σ3 grain boundaries to 100% of the total grain boundary length in the region A is less than 60%, coarsening of crystal grains is suppressed, improving chipping resistance and thereby further improving fracture resistance. The combining of the above configurations allows for the coated cutting tool of the present embodiment to have improved wear resistance and fracture resistance, and accordingly, it can be considered that the tool life can be extended.

FIG. 1 is a schematic cross-sectional view showing an example of the coated cutting tool of the present embodiment. A coated cutting tool 6 is provided with a substrate 1 and a coating layer 5 located on a surface of the substrate 1, and a lower layer 2, an intermediate layer 3 and an upper layer 4 are laminated in this order from the substrate side in an upward direction in the coating layer 5.

The coated cutting tool according to the present embodiment comprises a substrate and a coating layer formed on a surface of the substrate. Specific examples of types of the coated cutting tool include an indexable cutting insert for milling or turning, a drill and an end mill.

The substrate used in the present embodiment is not particularly limited, as long as it may be used as a substrate for a coated cutting tool. Examples of such substrate include a cemented carbide, cermet, ceramic, a cubic boron nitride sintered body, a diamond sintered body and high-speed steel. From among the above examples, the substrate is preferably comprised of a cemented carbide, cermet, ceramic or a cubic boron nitride sintered body as this provides further excellent wear resistance and fracture resistance, and, from the same perspective, the substrate is more preferably comprised of a cemented carbide.

It should be noted that the surface of the substrate may be modified. For instance, when the substrate is comprised of a cemented carbide, a β-free layer may be formed on the surface thereof, and when the substrate is comprised of cermet, a hardened layer may be formed on the surface thereof. The operation and effects of the present invention are still provided even if the substrate surface has been modified in this way.

The coating layer used in the present embodiment preferably has an average total thickness of 10.0 µm or more and 30.0 µm or less. When the coating layer of the coated cutting tool of the present embodiment has an average total thickness of 10.0 µm or more, wear resistance tends to improve; when the coating layer has an average total thickness of 30.0 µm or less, peeling of the coating layer is suppressed, and fracture resistance is improved. From the same viewpoint, the average thickness of the entire coating layer is more preferably 13.0 µm or more and 28.7 µm or less, and even more preferably 14.0 µm or more and 26.2 µm or less.

It should be noted that, as to the average thickness of each layer and the average thickness of the entire coating layer in the coated cutting tool of the present embodiment, each of such average thicknesses can be obtained by: measuring the thickness of each layer or the thickness of the entire coating layer from each of the cross-sectional surfaces at three or more locations in each layer or in the entire coating layer; and then calculating the arithmetic mean of the resulting measurements.

### Lower layer

The lower layer used in the present embodiment comprises one or more Ti compound layers containing, preferably consisting essentially of, more preferably consisting of a Ti compound formed of Ti and an element of at least one kind selected from the group consisting of C, N, O, and B. When the coated cutting tool has a lower layer between the substrate and the intermediate layer comprising an α-Al₂O₃ layer, both wear resistance and adhesion are improved.

The lower layer may be constituted by a single layer or multiple layers (for example, two or three layers). However, the lower layer is preferably constituted by multiple layers, is more preferably constituted by two or three layers, and is even more preferably constituted by three layers. The Ti compound constituting the Ti compound layer in the lower layer is preferably at least one selected from the group consisting of TiN, TiC, TiCN, TiCO, TiCNO, TiON, and TiB₂, from the viewpoint of further improvement in wear resistance and adhesion. At least one selected from the group consisting of TiN, TiC, TiCN, TiCO, and TiCNO is more preferred. Furthermore, at least one lower layer of the coated cutting tool of the present embodiment is preferably a TiCN layer, because wear resistance is further improved. When the lower layer is constituted by three layers: a TiC layer or a TiN layer, serving as a first layer, may be formed on a surface of the substrate; a TiCN layer, serving as a second layer, may be formed on a surface of the first layer; and a TiCNO layer or a TiCO layer, serving as a third layer, may be formed on a surface of the second layer. In particular, as to the lower layer: a TiN layer, serving as a first layer, may be formed on a surface of the substrate; a TiCN layer, serving as a second layer, may be formed on a surface of the first layer; and a TiCNO layer, serving as a third layer, may be formed on a surface of the second layer.

The lower layer used in the present embodiment has an average thickness of 3.0 µm or more and 15.0 µm or less. When the lower layer of the coated cutting tool of the present embodiment has an average thickness of is 3.0 µm or more, flank wear is suppressed, and wear resistance is improved. On the other hand, when the lower layer of the coated cutting tool of the present embodiment has an average thickness of 15.0 µm or less, peeling of the coating layer is suppressed, and fracture resistance is improved. From the same perspective, the average thickness of the lower layer is more preferably 3.5 µm or more and 14.5 µm, and further preferably 4.5 µm or more and 13.0 µm or less.

The average thickness of the TiC layer or TiN layer in the lower layer is preferably 0.05 µm or more and 1.00 µm or less from the viewpoint of further improvement in wear resistance and fracture resistance. From the same perspective, the average thickness of the TiC layer or TiN layer in the lower layer is more preferably 0.10 µm or more and 0.50 µm or less, and further preferably 0.15 µm or more and 0.30 µm or less.

The average thickness of the TiCN layer in the lower layer is preferably 2.0 µm or more and 15.0 µm or less from the viewpoint of further improvement in wear resistance and fracture resistance. From the same viewpoint, the average thickness of the TiCN layer in the lower layer is more preferably 3.0 µm or more and 14.0 µm or less, and even more preferably 4.0 µm or more and 12.5 µm or less.

The average thickness of the TiCNO layer or TiCO layer in the lower layer is preferably 0.05 µm or more and 1.50 µm or less from the viewpoint of further improvement in wear resistance and fracture resistance. From the same viewpoint, the average thickness of the TiCNO layer or TiCO layer in the lower layer is more preferably 0.10 µm or more and 1.00 µm or less, and even more preferably 0.20 µm or more and 0.50 µm or less.

The Ti compound layer in the lower layer is composed of a Ti compound of Ti and an element of at least one kind selected from the group consisting of C, N, O and B. However, such Ti compound layer may contain a very small amount of components other than the above elements, as long as it provides the operation and effects of the lower layer.

### Intermediate Layer

The intermediate layer used in the present embodiment comprises an α-Al₂O₃ layer composed of α-aluminum oxide (α-Al₂O₃).

The intermediate layer used in the present embodiment has an average thickness of 3.0 µm or more and 15.0 µm or less. In the coated cutting tool of the present embodiment, when the average thickness of the intermediate layer is 3.0 µm or more, crater wear is suppressed, and thus wear resistance is improved. On the other hand, in the coated cutting tool of the present embodiment, when the average thickness of the intermediate layer is 15.0 µm or less, peeling of the coating layer is suppressed, and thus fracture resistance is improved. From the same perspective, the average thickness of the intermediate layer is more preferably 4.5 µm or more and 12.5 µm or less, and further preferably 6.0 µm or more and 10.0 µm or less.

The intermediate layer may have a layer composed of α-aluminum oxide (α-Al₂O₃). As long as the effects of the present invention can be achieved, the intermediate layer may contain components other than α-aluminum oxide (α-Al₂O₃) or may be free from such components.

The mean spacing of profile irregularities RSm on the surface of the intermediate layer used in the present embodiment is preferably 5 µm or more and 20 µm or less. In the coated cutting tool of the present embodiment, when the mean spacing of profile irregularities RSm on the surface of the intermediate layer is 5 µm or more, the spacing between adjacent convex portions on the surface of the intermediate layer is increased, and initiation of fracture at the convex portions can be suppressed, resulting in improved fracture resistance. Furthermore, in the region A described later, the ratio of the total length of Σ3 grain boundaries to 100% of the total grain boundary length, tends to easily increase. On the other hand, when the mean spacing of profile irregularities RSm on the surface of the intermediate layer is 20 µm or less, the adhesion between the intermediate layer and the upper layer is improved due to the surface unevenness of the intermediate layer, and peeling is suppressed, thereby improving fracture resistance. From the same perspective, the mean spacing of profile irregularities RSm on the surface of the intermediate layer is more preferably 6 µm or more and 18 µm or less, and further preferably 7 µm or more and 16 µm or less.

The mean spacing of profile irregularities RSm on the surface of the intermediate layer can be determined by the method described in Examples below.

### Upper Layer

The upper layer used in the present embodiment comprises one or more Ti compound layers containing, preferably consisting essentially of, more preferably consisting of a Ti compound formed of Ti and an element of at least one kind selected from the group consisting of C, N, O, and B, and comprises at least one TiCN layer containing TiCN.

The upper layer used in the present embodiment comprises one or more Ti compound layers containing a Ti compound formed of Ti and an element of at least one kind selected from the group consisting of C, N, O, and B, and comprises at least one TiCN layer containing TiCN, thereby improving wear resistance. Furthermore, since the upper layer comprises, on the outer side of the α-Al₂O₃ layer of the intermediate layer, a TiCN layer in which both the proportion of the area occupied by the region A (described later) and the ratio of the total length of Σ3 grain boundaries to 100% of the total grain boundary length in the region A are controlled, both wear resistance and fracture resistance are improved.

Ti compound layers other than the TiCN layer in the upper layer are not particularly limited, and examples thereof include a TiC layer containing, preferably consisting essentially of, more preferably consisting of TiC, a TiN layer containing, preferably consisting essentially of, more preferably consisting of TiN, a TiCO layer containing, preferably consisting essentially of, more preferably consisting of TiCO, a TiCNO layer containing, preferably consisting essentially of, more preferably consisting of TiCNO, and a TiON layer containing, preferably consisting essentially of, more preferably consisting of TiON.

The upper layer may be constituted by a single layer or multiple layers (for example, two or three layers). When the upper layer is constituted by multiple layers, it is preferable to form the TiCNO layer or the TiN layer as a layer on a side in contact with the intermediate layer, and another layer may be formed on the surface of the TiCN layer opposite to the substrate. When the upper layer is composed of two layers, a TiCNO layer or a TiN layer may be formed as a X layer, and a TiCN layer may be formed on the surface of the X layer as a Y layer. When the upper layer is composed of three layers, a TiCNO layer or TiN layer may be formed as a X layer on the side in contact with the intermediate layer, a TiCN layer may be formed on the surface of the X layer as a Y layer, and a TiN layer may be formed on the surface of the Y layer as a Z layer.

The average thickness of the upper layer used in the present embodiment is 1.0 µm or more and 6.0 µm or less. In the coated cutting tool of the present embodiment, since the average thickness of the upper layer is 1.0 µm or more, flank wear is suppressed, and thus wear resistance is improved. On the other hand, in the coated cutting tool of the present embodiment, since the average thickness of the upper layer is 6.0 µm or less, peeling of the coating layer is suppressed, and thus fracture resistance is improved. From the same viewpoint, the average thickness of the upper layer is preferably 1.2 µm or more and 5.2 µm or less, and more preferably 1.5 µm or more and 4.2 µm or less.

The average thickness of the TiCN layer in the upper layer is preferably 0.5 µm or more and 6.0 µm or less from the viewpoint of further improvement in wear resistance and fracture resistance. From the same perspective, the average thickness of the TiCN layer in the upper layer is preferably 0.8 µm or more and 5.0 µm or less, and more preferably 1.2 µm or more and 4.5 µm or less.

The average thickness of the TiCNO layer in the upper layer is preferably 0.1 µm or more and 1.0 µm or less from the viewpoint of further improvement in wear resistance and fracture resistance. From the same perspective, the average thickness of the TiCNO layer in the upper layer is more preferably 0.2 µm or more and 0.8 µm or less, and further preferably 0.3 µm or more and 0.6 µm or less.

The average thickness of the TiN layer in the upper layer is preferably 0.05 µm or more and 1.00 µm or less from the viewpoint of further improvement in wear resistance and fracture resistance. From the same perspective, the average thickness of the TiN layer in the upper layer is more preferably 0.10 µm or more and 0.50 µm or less, and further preferably 0.15 µm or more and 0.25 µm or less.

When the upper layer used in the present embodiment is in contact with the intermediate layer, the upper layer may include at least one layer selected from the group consisting of a layer composed of TiN, a layer composed of TiCO, a layer composed of TiON, and a layer composed of TiCNO as an adhesion layer on the side in contact with the intermediate layer (hereinafter also referred to simply as a "adhesion layer"). With such an adhesion layer, the upper layer used in the present embodiment tends to have improved adhesion between the upper layer and the intermediate layer. From the same viewpoint, a TiN layer or a TiCNO layer is more preferable as the adhesion layer.

In the upper layer used in the present embodiment, the average thickness of the adhesion layer is preferably 0.1 µm or more and 1.0 µm or less. In the coated cutting tool of the present embodiment, where the average thickness of the adhesion layer is 0.1 µm or more, the adhesion between the upper layer and the intermediate layer tends to be excellent and the fracture resistance tends to be improved. Meanwhile, in the coated cutting tool of the present embodiment, where the average thickness of the adhesion layer is 1.0 µm or less, the wear resistance tends to be improved. From the same viewpoint, the average thickness of the adhesion layer is more preferably 0.2 µm or more and 0.8 µm or less, and even more preferably 0.3 µm or more and 0.6 µm or less.

The Ti compound layer in the upper layer is composed of a Ti compound of Ti and an element of at least one kind selected from the group consisting of C, N, O and B. However, such Ti compound layer may contain a very small amount of components other than the above elements, as long as it provides the operation and effects of the upper layer.

In the coated cutting tool of the present embodiment, in a cross section of the TiCN layer of the upper layer parallel to the surface of the substrate, when a sum of areas of an entire cross section is taken as 100 area%, the ratio of a sum of cross-sectional areas of regions A, where the misorientation A is 0 degrees or more and less than 15 degrees, is 30 area% or more and 70 area% or less.

Here, the cross section exposed parallel to the surface of the substrate at a position where 30% or more and 90% or less of the average thickness of the TiCN layer in the upper layer remains from the substrate side is specified as the location for analyzing the ratio of the sum of cross-sectional areas of regions A.

In the coated cutting tool of the present embodiment, since the RSA is 30 area% or more, detachment of particles caused by mechanical and thermal shocks is suppressed, and thus fracture resistance is improved. On the other hand, in the coated cutting tool of the present embodiment, since the RSA is 70 area% or less, wear resistance is improved. From the same perspective, the RSA is more preferably 31 area% or more and 68 area% or less, and further preferably 34 area% or more and 62 area% or less.

In the present embodiment, the RSA can be determined by the method described in Examples below.

In the coated cutting tool of the present embodiment, in the region A of the TiCN layer in the upper layer, the ratio of the total length of Σ3 grain boundaries to 100% of the total grain boundary length, is 30% or more and less than 60%. In the coated cutting tool of the present embodiment, when the ratio of the total length of Σ3 grain boundaries to 100% of the total grain boundary length, is 30% or more in the region A of the TiCN layer in the upper layer, the effect of suppressing particle detachment achieved by an RSA of 30 area% or more is further enhanced, thereby improving fracture resistance. In addition, since mechanical properties are improved, crater wear is suppressed and wear resistance is also improved. On the other hand, in the coated cutting tool of the present embodiment, when the ratio of the total length of Σ3 grain boundaries to 100% of the total grain boundary length in the region A is less than 60%, coarsening of crystal grains is suppressed, improving chipping resistance and thereby further improving fracture resistance. From the same perspective, the ratio of the total length of Σ3 grain boundaries to 100% of the total grain boundary length in region A is preferably 35% or more and 55% or less, and more preferably 40% or more and 50% or less.

In the coated cutting tool of the present embodiment, from the viewpoint of the improvement in thermal shock resistance and fracture resistance, the ratio of the total length of Σ3 grain boundaries to 100% of the total grain boundary length is preferably more than 0% and less than 30% in the entire cross section of the TiCN layer in the upper layer parallel to the surface of the substrate. From the same perspective, the ratio of the total length of Σ3 grain boundaries to 100% of the total grain boundary length in the entire cross section of the TiCN layer in the upper layer parallel to the surface of the substrate is preferably more than 3% and less than 25%, more preferably more than 5% and less than 22%, and further preferably more than 10% and less than 20%.

Here, the cross section exposed parallel to the surface of the substrate at a position where 30% or more and 90% or less of the average thickness of the TiCN layer in the upper layer remains from the substrate side is specified as the location for analyzing the ratio of the total length of Σ3 grain boundaries to 100% of the total grain boundary length.

In the present application, the length of CSL grain boundaries refers to the total length of coincidence site lattice boundaries represented by combinations of Σ and a number, such as Σ3, Σ5, Σ7, Σ9, Σ11, Σ13, Σ15, Σ17, Σ19, Σ21, Σ23, Σ25, Σ27, and Σ29 grain boundaries.

The TiCN layer in the upper layer of the present embodiment includes crystal grain boundaries with relatively high grain boundary energy and those with relatively low grain boundary energy. Generally, crystal grain boundaries have irregular atomic arrangements and are randomly oriented, resulting in many voids and relatively high grain boundary energy. In contrast, some crystal grain boundaries have regular atomic arrangements with fewer voids, and such grain boundaries have relatively low grain boundary energy. A representative example of crystal grain boundaries having relatively low grain boundary energy is a coincidence site lattice boundary (hereinafter also referred to as a CSL grain boundary or CSL boundary). Crystal grain boundaries have a significant influence on important sintering processes such as densification, creep, and diffusion, as well as on electrical, optical, and mechanical properties. The significance of crystal grain boundaries depends on several factors, such as the grain boundary density within the material, the chemical composition at the interfaces, and the crystallographic configuration, namely, the orientation of the boundary plane and the misorientation between adjacent grains. The CSL grain boundaries play a special role. The Σ value is known as an indicator of the degree of distribution of CSL grain boundaries. The Σ value is defined as the ratio of the density of coinciding lattice points, obtained when the two crystal lattices in contact at a grain boundary are superimposed, to the lattice point density of either crystal grain. In simple crystal structures, grain boundaries with low Σ values are generally recognized to have low interfacial energy and exhibit special properties. Therefore, controlling the proportion of CSL grain boundaries and the distribution of crystal grain misorientation is important for improving the properties of the TiCN layer.

Recently, a technique based on scanning electron microscopy (hereinafter also referred to as "SEM"), known as electron backscatter diffraction (hereinafter also referred to as "EBSD"), has been used to study crystal grain boundaries in materials. EBSD is based on the automated analysis of Kikuchi diffraction patterns generated by backscattered electrons.

For each crystal grain of the material under investigation, the crystallographic orientation is determined after indexing the corresponding diffraction pattern. EBSD, when combined with commercially available software, enables relatively easy microstructural analysis and determination of the grain boundary character distribution (GBCD). EBSD measurements and analyses of interfaces enable the identification of grain boundary misorientation across a large dataset of interfaces. In general, the distribution of misorientation is related to the processing and/or physical properties of the material. The misorientation of crystal grain boundaries can be derived from typical orientation parameters such as Euler angles, angle/axis pairs, or Rodrigues vectors.

The CSL grain boundaries in the TiCN layer generally consist of Σ3, Σ5, Σ7, Σ9, Σ11, Σ13, Σ15, Σ17, Σ19, Σ21, Σ23, Σ25, Σ27, and Σ29 boundaries. Here, for example, the length of Σ3 grain boundaries refers to the total length of Σ3 grain boundaries observed within a specific field of view by a scanning electron microscope (SEM) equipped with EBSD.

In this context, the term "total grain boundaries" refers to the sum of CSL grain boundaries and non-CSL grain boundaries. The non-CSL grain boundaries are hereinafter referred to as "general grain boundaries" or "random grain boundaries." The general grain boundaries are defined as the boundaries remaining after subtracting the CSL grain boundaries from all the grain boundaries of the TiCN layer observed using a scanning electron microscope (SEM) equipped with EBSD. Accordingly, the "total length of all grain boundaries" can be expressed as the sum of the lengths of the CSL grain boundaries and the general grain boundaries.

In this embodiment, the ratio of the total length of Σ3 grain boundaries to 100% of the total grain boundary length in the entire cross section of the TiCN layer in the upper layer, as well as the ratio of the total length of Σ3 grain boundaries to 100% of the total grain boundary length in the region A of the TiCN layer in the upper layer can be calculated as follows.

A cross section of the TiCN layer in the upper layer of the coated cutting tool is exposed parallel to the surface of the substrate, thereby obtaining an observation surface. As a method for exposing the cross section of the TiCN layer in the upper layer, cutting or polishing may be employed. Among these, polishing is preferred from the viewpoint of making the observation surface of the TiCN layer smoother. In particular, the observation surface is preferably a mirror surface in terms of smoothness. The method for obtaining a mirror-polished observation surface of the TiCN layer is not particularly limited. Examples include polishing with diamond paste or colloidal silica, and ion milling.

Thereafter, the observation surface obtained as described above is observed using a SEM equipped with EBSD. The rake face is preferably used as the observation region.

The SEM used is SU6600 (manufactured by Hitachi High-Technologies Corporation) equipped with EBSD (manufactured by TexSEM Laboratories).

The normal to the observation surface is inclined at 70° to the incident beam, and the analysis is performed by irradiating the surface with an electron beam at an accelerating voltage of 15 kV and a beam current of 1.0 nA. Data collection is performed under EBSD conditions with a measurement area of 120 µm × 120 µm and a step size (distance between measurement points) of 0.1 µm, by analyzing the crystal orientation of individual TiCN grain in the upper layer. At this stage, boundaries between adjacent measurement points with a difference in crystal orientation of 5° or more are defined as grain boundaries.

Data processing is performed using commercially available software. The ratio of the total length of Σ3 grain boundaries to 100% of the total grain boundary length can be determined by counting the CSL grain boundaries corresponding to any Σ value and expressing them as a ratio to all grain boundaries. Accordingly, the lengths of Σn grain boundaries (where n is an odd number between 3 and 29), the total length of CSL grain boundaries, and the total length of all grain boundaries are determined for the TiCN layer. Within the measurement range on the above-mentioned observation surface, three fields of view are analyzed in total, and the average value of each measurement is determined. From the obtained average values, the ratio of the total length of Σ3 grain boundaries to 100% of the total grain boundary length in the entire cross section of the TiCN layer in the upper layer, as well as that in the region A of the TiCN layer in the upper layer, can be calculated.

### Method for Forming Coating Layer

For example, the following methods can be used for forming the layers constituting the coating layer in the coated cutting tool of the present embodiment. However, the method of forming such layers is not limited thereto.

Firstly, a lower layer, being comprised of one or more Ti compound layers, is formed on a surface of a substrate. Next, from among such layers, a surface of a layer which is most distant from the substrate is oxidized. Then, nuclei of an α-Al₂O₃ layer are formed on the surface most distant from the substrate, and with the nuclei thus formed, the α-Al₂O₃ layer is formed in two stages. Further, an upper layer, being comprised of a Ti compound layer including a TiCN layer, is formed on a surface of the α-Al₂O₃ layer.

Examples of the method of forming the Ti compound layer in the lower layer include, but are not particularly limited to, the following methods.

For example, a Ti compound layer composed of a titanium nitride layer (hereinafter also referred to as a "TiN layer") in the lower layer can be formed by chemical vapor deposition under the conditions of a raw material composition of TiCl₄: 5.0 to 10.0 mol%, N₂: 20 to 60 mol%, and H₂: the balance, a temperature of from 850 to 950°C, a pressure of from 350 to 450 hPa, and a gas flow rate of 40 to 80 L/min.

A Ti compound layer, being comprised of a Ti carbide layer (hereinafter also referred to as a "TiC layer") in the lower layer, can be formed by chemical vapor deposition with a raw material composition of TiCl₄: from 1.5 mol% or more to 3.5 mol% or less, CH₄: from 3.5 mol% or more to 5.5 mol% or less, and H₂: the balance, a temperature of from 950°C or higher to 1,050°C or lower, a pressure of from 70 hPa or higher to 80 hPa or lower, and a gas flow rate of 30 to 70 L/min.

A Ti compound layer, being comprised of a Ti carbonitride layer (hereinafter also referred to as a "TiCN layer") in the lower layer, can be formed by chemical vapor deposition with a raw material composition of TiCl₄: from 5.0 mol% or more to 7.0 mol% or less, CH₃CN: from 0.5 mol% or more to 1.5 mol% or less, and H₂: the balance, a temperature of from 800°C or higher to 900°C or lower, a pressure of from 70 hPa or higher to 90 hPa or lower, and a gas flow rate of 50 to 90 L/min.

A Ti compound layer, being comprised of a Ti oxycarbonitride layer (hereinafter also referred to as a "TiCNO layer") in the lower layer, can be formed by chemical vapor deposition with a raw material composition of TiCl₄: from 3.0 mol% or more to 4.0 mol% or less, CO: from 0.5 mol% or more to 1.0 mol% or less, N₂: from 30 mol% or more to 40 mol% or less and H₂: the balance, a temperature of from 950°C or higher to 1050°C or lower, a pressure of from 50 hPa or higher to 150 hPa or lower, and a gas flow rate of 30 to 70 L/min.

A Ti compound layer, being comprised of a Ti carboxide layer (hereinafter also referred to as a "TiCO layer") in the lower layer, can be formed by chemical vapor deposition with a raw material composition of TiCl₄: from 1.0 mol% or more to 2.0 mol% or less, CO: from 2.0 mol% or more to 3.0 mol% or less, and H₂: the balance, a temperature of from 950°C or higher to 1,050°C or lower, a pressure of from 50 hPa or higher to 150 hPa or lower, and a gas flow rate of 30 to 70 L/min.

An intermediate layer, being comprised of an α-Al₂O₃ layer (hereinafter also simply referred to as an "Al₂O₃ layer"), can be obtained by, for example, the method set forth below.

First, the oxidation of the surface of the layer which is most distant from the substrate among the lower layers is performed under the conditions of the raw material composition of CO₂: from 0.1 to 1.0 mol% and H₂: the balance, a temperature of from 950 to 1,000°C, a pressure of from 60 to 80 hPa and a gas flow rate of 5 to 15 L/min (oxidation step). The oxidation treatment time in this case is preferably is 1 to 5 minutes.

Thereafter, nuclei of the α-Al₂O₃ layer are formed by chemical vapor deposition with a raw material composition of AlCl₃: from 1.0 mol% or more to 4.0 mol% or less, CO: from 0.05 mol% or more to 2.0 mol% or less, CO₂: from 1.0 mol% or more to 3.0 mol% or less, HCl: from 2.0 mol% or more to 3.0 mol% or less, and H₂: the balance, a temperature of from 950°C or higher to 1050°C or lower, a pressure of from 60 hPa or higher to 80 hPa or lower, and a gas flow rate of 50 to 90 L/min (nucleation step). A preferred time of the nucleation step is from 3 to 30 minutes.

Next, the first α-Al₂O₃ layer is formed by chemical vapor deposition under the conditions of the raw material composition of AlCl₃: 1.5 to 3.5 mol%, CO₂: 0.5 to 2.5 mol%, HCl: 1.5 to 3.5 mol%, H₂S: 0.10 to 0.40 mol%, and H₂: the balance, a temperature of from 980 to 1,040°C, a pressure of from 70 to 110 hPa, and a gas flow rate of 50 to 90 L/min (the first film formation step).

Then, the second α-Al₂O₃ layer is formed by chemical vapor deposition under the conditions of a raw material composition of AlCl₃: 1.5 to 3.5 mol%, CO₂: 1.0 to 5.0 mol%, HCl: 1.5 to 3.5 mol%, and H₂: the balance, a temperature of from 850 to 940°C, a pressure of from 70 to 110 hPa, and a gas flow rate of 50 to 90 L/min (Second film formation step).

In order to set the mean spacing of profile irregularities RSm on the surface of the intermediate layer to the above specific range, for example, the intermediate layer may be formed by combining the first film formation step using H₂S as a raw material and the second film formation step without using H₂S, or by controlling the temperature or raw material composition ratio in the second film formation step. More specifically, combining the first and the second film formation steps facilitates an increase in RSm. Although the mechanism is not limited to the following, it is considered that when the intermediate layer is formed by combining the first and the second film formation steps having significantly different preferential growth orientations, part of the convex portions formed during the first film formation step disappear in the course of the second step, resulting in an increase in RSm.

Furthermore, lowering the temperature during the second film formation step tends to increase RSm. In addition, increasing the proportion of CO₂ in the raw material composition facilitates a further increase in RSm.

Further, examples of the method for forming the upper layer include, but are not particularly limited to, the following methods. Firstly, when an adhesion layer is formed on a side in contact with an intermediate layer (α-Al₂O₃ layer), a Ti compound layer (adhesion layer) is formed on a surface of the α-Al₂O₃ layer as the first step of forming the upper layer. Then, a TiCN layer is formed on the surface of the adhesion layer as the second step of forming the upper layer. In addition, a Ti compound layer may be formed on the surface of the TiCN layer as the outermost layer in the upper layer. Moreover, in the first step for forming the upper layer, a TiCN layer may be formed on the surface of the α-Al₂O₃ layer, and subsequently, in the second step for forming the upper layer, an additional Ti compound layer (outermost layer) may be formed.

For example, when a TiCNO layer is formed on the surface of the α-Al₂O₃ layer as the first step of forming the upper layer, the TiCNO layer can be formed by chemical vapor deposition with a raw material composition of TiCl₄: from 7.5 to 9.5 mol%, CH₄: from 1.0 to 2.0 mol%, CO: from 0.3 to 1.7 mol%, N₂: from 5.0 to 30.0 mol%, and H₂: the balance, a temperature of from 860 to 940°C, a pressure of from 110 to 190 hPa, and a gas flow rate of 70 to 110 L/min.

For example, when a TiN layer is formed on the surface of the α-Al₂O₃ layer as the first step of forming the upper layer, the TiN layer can be formed by chemical vapor deposition with a raw material composition of TiCl₄: from 6.0 to 10.0 mol%, N₂: from 10.0 to 30.0 mol%, and H₂: the balance, a temperature of from 840 to 920°C, a pressure of from 170 to 190 hPa, and a gas flow rate of 90 to 110 L/min.

When forming a TiCN layer in the first step or the second step for forming the upper layer, the TiCN layer may be formed by chemical vapor deposition under the conditions of a raw material composition of TiCl₄: 7.0 to 10.0 mol%, CH₄: 0.1 to 2.0 mol%, CH₃CN: 0.3 to 1.3 mol%, N₂: 10.0 to 25.0 mol%, and H₂: the balance, a temperature of from 860 to 940°C, a pressure of from 110 to 190 hPa, and a gas flow rate of 80 to 110 L/min.

Further, when a TiN layer is formed on the surface of the TiCN layer, the TiN layer can be formed by chemical vapor deposition with a raw material composition of TiCl₄: from 5.0 to 10.0 mol%, N₂: from 20.0 to 60.0 mol%, and H₂: the balance, a temperature of from 950 to 1050°C, a pressure of from 300 to 400 hPa, and a gas flow rate of 50 to 90 L/min.

In order to set the ratio of the total length of Σ3 grain boundaries to 100% of the total grain boundary length in the entire cross section of the TiCN layer in the upper layer to the above specific range, for example, the proportion of N₂ in the raw material composition in the first or second step for forming the TiCN layer as the upper layer may be adjusted. More specifically, increasing the proportion of N₂ in the raw material composition in the first or second step for forming the TiCN layer as the upper layer facilitates an increase in the ratio of the total length of Σ3 grain boundaries to 100% of the total grain boundary length in the entire cross section of the TiCN layer in the upper layer.

In order to set the ratio of the total length of Σ3 grain boundaries to 100% of the total grain boundary length in the region A of the TiCN layer in the upper layer to the above specific range, for example, the proportion of N₂ in the raw material composition in the first or second step for forming the TiCN layer as the upper layer may be adjusted, or the mean spacing of profile irregularities RSm on the surface of the intermediate layer may be adjusted. More specifically, increasing the proportion of N₂ in the raw material composition in the first or second step for forming the TiCN layer as the upper layer facilitates an increase in the ratio of the total length of Σ3 grain boundaries to 100% of the total grain boundary length in the region A of the TiCN layer in the upper layer. Moreover, increasing the mean spacing of profile irregularities RSm on the surface of the intermediate layer facilitates an increase in the ratio of the total length of Σ3 grain boundaries to 100% of the total grain boundary length in the region A of the TiCN layer in the upper layer.

In order to set the RSA of the upper layer to the above specific range, for example, the proportion of CH₄ in the composition or the gas flow rate in the first or second step for forming the TiCN layer as the upper layer may be adjusted. More specifically, increasing the proportion of CH₄ in the raw material composition in the first or second step for forming the TiCN layer as the upper layer facilitates an increase in the RSA. Likewise, increasing the gas flow rate in the first or second step for forming the TiCN layer as the upper layer tends to increase the RSA.

The thickness of each layer in the coating layer of the coated cutting tool of the present embodiment can be measured by observing a cross-sectional structure of the coated cutting tool, using an optical microscope, a scanning electron microscope (SEM), a FE-SEM, or the like. It should be noted that, as to the average thickness of each layer in the coated cutting tool of the present embodiment, such average thickness can be obtained by: measuring the thickness of each layer at three or more locations near the position 50 µm from the edge, toward the center of the flank of the coated cutting tool; and calculating the arithmetic mean of the resulting measurements. Further, the composition of each layer can be measured from a cross-sectional structure of the coated cutting tool of the present embodiment, using an energy-dispersive X-ray spectroscope (EDS), a wavelength-dispersive X-ray spectroscope (WDS), or the like.

### Examples

Hereinafter, the present invention will be described in greater detail with reference to examples, but the present invention is not limited to these examples.

As a substrate, a cutting insert made of a cemented carbide having a composition of 87.0%WC-8.6%Co-2.0%TiN-2.0%NbC-0.4%Cr₃C₂ (the above numbers are mass%) and having an insert shape of CNMG120412 (ISO standard) was prepared. The edges of these substrates were subjected to round honing by means of an SiC brush, and surfaces of the substrates were then washed.

### Invention Samples 1 to 29 and Comparative Samples 1 to 14

After the substrate surface was washed, a coating layer was formed by chemical vapor deposition. Firstly, the lower layer was formed on a surface of the substrate. More specifically, the substrate was placed in an externally heated chemical vapor deposition apparatus, and under the conditions of raw material composition, temperature, pressure, and gas flow rate shown in Table 1, a first layer having the composition and the average thickness shown in Table 7 was formed on the surface of the substrate. Next, under the conditions of raw material composition, temperature, pressure, and gas flow rate shown in Table 1, a second layer having the composition and the average thickness shown in Table 7 was formed on the surface of the first layer. Then, under the conditions of raw material composition, temperature, pressure, and gas flow rate shown in Table 1, a third layer having the composition and the average thickness shown in Table 7 was formed on the surface of the second layer. As a result, a lower layer composed of three layers was formed.

The oxidation treatment (oxidation step) was then carried out on the surface of the lower layer under the conditions of composition, temperature, pressure, and gas flow rate shown in Table 2. The oxidation time was set to 3 minutes. Next, in the nucleation step, nuclei of α-aluminum oxide (α-Al₂O₃) were formed on the surface of the oxidized lower layer under conditions of raw material composition, temperature, pressure, and gas flow rate shown in Table 2. The time for the nucleation step was set to 10 minutes. Furthermore, in the first film formation step, under conditions of raw material composition, temperature, and pressure shown in Table 3, and the gas flow rate conditions shown in Table 2, an intermediate layer having the composition shown in Table 8 was formed on the surface of the α-aluminum oxide (α-Al₂O₃) nuclei. For Invention Samples 1 to 29 and Comparative Samples 1 to 11 and 14, the duration of the first film formation step for forming the intermediate layer was set such that the average thickness of the intermediate layer after the first film formation step reached approximately 80% of the average thickness shown in Table 8. Next, in the second film formation step, under conditions of raw material composition, temperature, and pressure shown in Table 4 and the gas flow rate conditions shown in Table 2, an intermediate layer having the composition and the average thickness shown in Table 8 was formed on the surface of the intermediate layer formed in the first film formation step. For Invention Samples 1 to 29 and Comparative Samples 1 to 11 and 14, the duration of the second film formation step for forming the intermediate layer was set such that the average thickness of the intermediate layer after the second film formation step reached the value shown in Table 8. For Invention Samples 1 to 29 and Comparative Samples 1 to 11 and 14, both the first and the second film formation steps for forming the intermediate layer were carried out to form the intermediate layer having the average thickness shown in Table 8. For Comparative Samples 12 and 13, only the first film formation step was performed, and the duration for forming the intermediate layer was set such that an intermediate layer having the average thickness shown in Table 8 was formed.

Subsequently, an upper layer was formed on the surface of the intermediate layer. Specifically, for Invention Samples 1 to 26 and Comparative Samples 1 to 14, in the first step for forming the upper layer, a X layer having the composition and the average thickness shown in Table 9 was formed on the surface of the intermediate layer, under conditions of raw material composition, temperature, pressure, and gas flow rate shown in Table 5. Next, in the second film formation step for forming the upper layer, a Y layer (TiCN layer) having the composition and the average thickness shown in Table 9 was formed on the surface of the X layer or on the surface of the intermediate layer, under conditions of raw material composition, temperature, pressure, and gas flow rate shown in Table 6. For Invention Samples 27 to 29, in the first step for forming the upper layer, a Y layer (TiCN layer) having the composition and the average thickness shown in Table 9 was formed on the surface of the intermediate layer. Further, for Invention Samples 1 to 6, 8, 10 to 24, and 26, and Comparative Samples 1 to 3 and 5 to 14, under the conditions of the raw material composition, temperature, pressure, and gas flow rate shown in Table 1, the Z layer having the composition shown in Table 9 was formed on the surface of the Y layer to have the average thickness shown in Table 9. In this way, coated cutting tools of Invention Samples 1 to 29 and Comparative Samples 1 to 14 were obtained.

The thickness of each of the layers of each of the obtained samples was obtained as set forth below. That is, using an FE-SEM, such average thickness was obtained by: measuring the thickness of each layer at each of the three locations from the cross-sectional surface near the position 50 µm from the edge of the coated cutting tool, toward the center of the rake face thereof; and calculating the arithmetic mean of the resulting measurements. The composition of each layer of the obtained samples was measured using EDS in a cross section in the vicinity of the position from the edge of the coated cutting tool to 50 µm toward the center of the rake face.

**[Table 1]**

| | Composition | Temperature (°C) | Pressure (hPa) | Raw material composition (mol%) | Gas flow rate (L/min) |
|---|---|---|---|---|---|
| Lower layer | TiN | 900 | 400 | TiCl₄:7.5%, N₂:40%, H₂:52.5% | 60 |
| | TiC | 1000 | 75 | TiCl₄:2.4%, CH₄:4.6%, H₂:93.0% | 50 |
| | TiCN | 850 | 80 | TiCl₄:6.0%, CH₃CN:1.15%, H₂:92.85% | 70 |
| | TiCNO | 1000 | 100 | TiCl₄:3.5%, CO:0.7%, N₂:35.5%, H₂:60.3% | 50 |
| | TiCO | 1000 | 80 | TiCl₄:1.3%, CO:2.7%, H₂:96.0% | 50 |
| Upper layer | TiN | 1000 | 350 | TiCl₄:7.5%, N₂:40.0%, H₂:52.5% | 70 |

**[Table 2]**

| Step | Temperature (°C) | Pressure (hPa) | Raw material composition (mol%) | Gas flow rate (L/min) |
|---|---|---|---|---|
| Oxidation step | 1000 | 70 | CO₂:0.5%, H₂:99.5% | 10 |
| Nucleation step | 1000 | 70 | AlCl₃:2.0%, CO:1.0%, CO₂:1.5%, HCl:2.5%, H₂:93.0% | 70 |
| First film formation step | Formed under conditions shown in Table 3 | | | 70 |
| Second film formation step | Formed under conditions shown in Table 4 | | | 70 |

**[Table 3]**

| Sample Number | Intermediate layer (First film formation step) | | | | | | |
|---|---|---|---|---|---|---|---|
| | Temperature (°C) | Pressure (hPa) | Raw material composition (mol%) | | | | |
| | | | AlCl₃ | CO₂ | HCl | H₂S | H₂ |
| Invention Sample 1 | 1020 | 90 | 2.5 | 1.5 | 2.5 | 0.25 | 93.25 |
| Invention Sample 2 | 1000 | 100 | 3.0 | 1.0 | 2.0 | 0.20 | 93.80 |
| Invention Sample 3 | 1020 | 90 | 2.5 | 1.5 | 2.5 | 0.30 | 93.20 |
| Invention Sample 4 | 1020 | 80 | 2.5 | 1.0 | 2.5 | 0.25 | 93.75 |
| Invention Sample 5 | 1020 | 100 | 3.0 | 1.5 | 3.0 | 0.25 | 92.25 |
| Invention Sample 6 | 1020 | 100 | 2.5 | 1.5 | 2.5 | 0.25 | 93.25 |
| Invention Sample 7 | 1000 | 80 | 2.5 | 2.0 | 2.5 | 0.25 | 92.75 |
| Invention Sample 8 | 1020 | 90 | 2.5 | 1.5 | 2.0 | 0.25 | 93.75 |
| Invention Sample 9 | 1020 | 100 | 2.5 | 1.5 | 2.5 | 0.25 | 93.25 |
| Invention Sample 10 | 1020 | 100 | 2.5 | 1.0 | 2.5 | 0.25 | 93.75 |
| Invention Sample 11 | 1020 | 90 | 3.0 | 1.5 | 2.5 | 0.25 | 92.75 |
| Invention Sample 12 | 1000 | 80 | 2.5 | 1.5 | 3.0 | 0.25 | 92.75 |
| Invention Sample 13 | 1020 | 100 | 2.0 | 2.0 | 2.5 | 0.20 | 93.30 |
| Invention Sample 14 | 1020 | 80 | 2.5 | 1.5 | 2.5 | 0.25 | 93.25 |
| Invention Sample 15 | 1020 | 100 | 2.5 | 1.5 | 2.5 | 0.25 | 93.25 |
| Invention Sample 16 | 1020 | 90 | 2.5 | 1.0 | 2.0 | 0.25 | 94.25 |
| Invention Sample 17 | 1020 | 90 | 3.0 | 1.5 | 2.5 | 0.30 | 92.70 |
| Invention Sample 18 | 1020 | 100 | 2.0 | 1.5 | 2.5 | 0.25 | 93.75 |
| Invention Sample 19 | 1000 | 80 | 2.5 | 2.0 | 3.0 | 0.25 | 92.25 |
| Invention Sample 20 | 1020 | 100 | 2.5 | 1.5 | 2.5 | 0.20 | 93.30 |
| Invention Sample 21 | 1020 | 100 | 2.5 | 1.5 | 2.5 | 0.25 | 93.25 |
| Invention Sample 22 | 1020 | 80 | 2.5 | 1.0 | 2.5 | 0.25 | 93.75 |
| Invention Sample 23 | 1000 | 90 | 2.5 | 1.5 | 2.0 | 0.25 | 93.75 |
| Invention Sample 24 | 1020 | 100 | 2.5 | 1.5 | 2.5 | 0.30 | 93.20 |
| Invention Sample 25 | 1000 | 90 | 2.5 | 2.0 | 2.5 | 0.25 | 92.75 |
| Invention Sample 26 | 1000 | 100 | 2.5 | 1.5 | 3.0 | 0.25 | 92.75 |
| Invention Sample 27 | 1020 | 90 | 3.0 | 2.0 | 2.5 | 0.25 | 92.25 |
| Invention Sample 28 | 1020 | 90 | 3.0 | 2.0 | 2.5 | 0.25 | 92.25 |
| Invention Sample 29 | 1020 | 90 | 3.0 | 2.0 | 2.5 | 0.25 | 92.25 |
| Comparative Sample 1 | 1000 | 100 | 3.0 | 1.5 | 2.5 | 0.25 | 92.75 |
| Comparative Sample 2 | 1020 | 80 | 2.5 | 1.5 | 2.5 | 0.25 | 93.25 |
| Comparative Sample 3 | 1020 | 100 | 2.5 | 2.0 | 2.0 | 0.25 | 93.25 |
| Comparative Sample 4 | 1020 | 90 | 2.0 | 1.5 | 2.5 | 0.30 | 93.70 |
| Comparative Sample 5 | 1000 | 80 | 3.0 | 1.5 | 3.0 | 0.20 | 92.30 |
| Comparative Sample 6 | 1020 | 80 | 3.0 | 1.0 | 2.5 | 0.25 | 93.25 |
| Comparative Sample 7 | 1020 | 100 | 2.0 | 1.5 | 2.5 | 0.25 | 93.75 |
| Comparative Sample 8 | 1000 | 100 | 2.5 | 2.0 | 3.0 | 0.25 | 92.25 |
| Comparative Sample 9 | 1000 | 90 | 2.5 | 1.5 | 2.5 | 0.20 | 93.30 |
| Comparative Sample 10 | 1020 | 90 | 2.5 | 1.5 | 2.0 | 0.25 | 93.75 |
| Comparative Sample 11 | 1000 | 100 | 3.0 | 1.0 | 2.5 | 0.25 | 93.25 |
| Comparative Sample 12 | 1000 | 100 | 2.0 | 1.0 | 2.5 | 0.20 | 94.30 |
| Comparative Sample 13 | 900 | 100 | 2.0 | 1.0 | 2.5 | 0.20 | 94.30 |
| Comparative Sample 14 | 1020 | 100 | 2.0 | 1.0 | 2.5 | 0.30 | 94.20 |

**[Table 4]**

| Sample Number | Intermediate layer (Second film formation step) | | | | | |
|---|---|---|---|---|---|---|
| | Temperature (°C) | Pressure (hPa) | Raw material composition (mol%) | | | |
| | | | AlCl₃ | CO₂ | HCl | H₂ |
| Invention Sample 1 | 890 | 90 | 2.5 | 3.0 | 2.5 | 92.0 |
| Invention Sample 2 | 890 | 100 | 3.0 | 3.0 | 2.0 | 92.0 |
| Invention Sample 3 | 890 | 90 | 2.5 | 3.0 | 2.5 | 92.0 |
| Invention Sample 4 | 890 | 80 | 2.5 | 3.0 | 2.5 | 92.0 |
| Invention Sample 5 | 890 | 100 | 3.0 | 3.0 | 3.0 | 91.0 |
| Invention Sample 6 | 890 | 100 | 2.5 | 3.0 | 2.5 | 92.0 |
| Invention Sample 7 | 890 | 80 | 2.5 | 3.0 | 2.5 | 92.0 |
| Invention Sample 8 | 890 | 90 | 2.5 | 3.0 | 2.0 | 92.5 |
| Invention Sample 9 | 890 | 100 | 2.5 | 3.0 | 2.5 | 92.0 |
| Invention Sample 10 | 890 | 100 | 2.5 | 3.0 | 2.5 | 92.0 |
| Invention Sample 11 | 920 | 90 | 3.0 | 2.0 | 2.5 | 92.5 |
| Invention Sample 12 | 890 | 80 | 2.5 | 3.0 | 3.0 | 91.5 |
| Invention Sample 13 | 870 | 100 | 2.0 | 3.0 | 2.5 | 92.5 |
| Invention Sample 14 | 890 | 80 | 2.5 | 3.0 | 2.5 | 92.0 |
| Invention Sample 15 | 890 | 100 | 2.5 | 3.0 | 2.5 | 92.0 |
| Invention Sample 16 | 890 | 90 | 2.5 | 3.0 | 2.0 | 92.5 |
| Invention Sample 17 | 920 | 90 | 3.0 | 1.5 | 2.5 | 93.0 |
| Invention Sample 18 | 870 | 100 | 2.0 | 4.5 | 2.5 | 91.0 |
| Invention Sample 19 | 890 | 80 | 2.5 | 3.0 | 3.0 | 91.5 |
| Invention Sample 20 | 890 | 100 | 2.5 | 3.0 | 2.5 | 92.0 |
| Invention Sample 21 | 890 | 100 | 2.5 | 3.0 | 2.5 | 92.0 |
| Invention Sample 22 | 890 | 80 | 2.5 | 3.0 | 2.5 | 92.0 |
| Invention Sample 23 | 890 | 90 | 2.5 | 3.0 | 2.0 | 92.5 |
| Invention Sample 24 | 890 | 100 | 2.5 | 3.0 | 2.5 | 92.0 |
| Invention Sample 25 | 890 | 90 | 2.5 | 3.0 | 2.5 | 92.0 |
| Invention Sample 26 | 890 | 100 | 2.5 | 3.0 | 3.0 | 91.5 |
| Invention Sample 27 | 890 | 90 | 3.0 | 3.0 | 2.5 | 91.5 |
| Invention Sample 28 | 890 | 90 | 3.0 | 3.0 | 2.5 | 91.5 |
| Invention Sample 29 | 890 | 90 | 3.0 | 3.0 | 2.5 | 91.5 |
| Comparative Sample 1 | 890 | 100 | 3.0 | 3.0 | 2.5 | 91.5 |
| Comparative Sample 2 | 890 | 80 | 2.5 | 3.0 | 2.5 | 92.0 |
| Comparative Sample 3 | 890 | 100 | 2.5 | 3.0 | 2.0 | 92.5 |
| Comparative Sample 4 | 890 | 90 | 2.0 | 3.0 | 2.5 | 92.5 |
| Comparative Sample 5 | 890 | 80 | 3.0 | 2.0 | 3.0 | 92.0 |
| Comparative Sample 6 | 920 | 80 | 3.0 | 1.5 | 2.5 | 93.0 |
| Comparative Sample 7 | 870 | 100 | 2.0 | 3.0 | 2.5 | 92.5 |
| Comparative Sample 8 | 890 | 100 | 2.5 | 3.0 | 3.0 | 91.5 |
| Comparative Sample 9 | 890 | 90 | 2.5 | 3.0 | 2.5 | 92.0 |
| Comparative Sample 10 | 890 | 90 | 2.5 | 3.0 | 2.0 | 92.5 |
| Comparative Sample 11 | 1000 | 100 | 3.0 | 3.0 | 2.5 | 91.5 |
| Comparative Sample 12 | - | - | - | - | - | - |
| Comparative Sample 13 | - | - | - | - | - | - |
| Comparative Sample 14 | 870 | 100 | 2.0 | 6.0 | 2.5 | 89.5 |

**[Table 5]**

| Sample Number | Upper layer (X layer) | | | | | | | |
|---|---|---|---|---|---|---|---|---|
| | Temperature (°C) | Pressure (hPa) | Raw material composition (mol%) | | | | | Gas flow rate (L/min) |
| | | | TiCl₄ | CH₄ | CO | N₂ | H₂ | |
| Invention Sample 1 | 880 | 150 | 8.5 | 1.5 | 0.5 | 20.0 | 69.5 | 90 |
| Invention Sample 2 | 900 | 150 | 8.0 | 1.5 | 0.5 | 20.0 | 70.0 | 90 |
| Invention Sample 3 | 900 | 150 | 8.0 | 1.5 | 1.0 | 20.0 | 69.5 | 90 |
| Invention Sample 4 | 880 | 150 | 8.0 | 1.5 | 1.0 | 20.0 | 69.5 | 90 |
| Invention Sample 5 | 900 | 180 | 8.5 | 1.5 | 1.0 | 20.0 | 69.0 | 90 |
| Invention Sample 6 | 900 | 150 | 8.0 | 1.5 | 1.5 | 20.0 | 69.0 | 90 |
| Invention Sample 7 | 900 | 150 | 8.0 | 1.5 | 1.0 | 20.0 | 69.5 | 90 |
| Invention Sample 8 | 920 | 150 | 9.0 | 1.5 | 1.0 | 20.0 | 68.5 | 90 |
| Invention Sample 9 | 900 | 150 | 8.0 | 1.5 | 1.5 | 20.0 | 69.0 | 90 |
| Invention Sample 10 | 900 | 150 | 8.0 | 1.5 | 1.0 | 20.0 | 69.5 | 90 |
| Invention Sample 11 | 900 | 120 | 9.0 | 1.5 | 0.5 | 10.0 | 79.0 | 90 |
| Invention Sample 12 | 880 | 150 | 8.0 | 1.5 | 1.0 | 25.0 | 64.5 | 90 |
| Invention Sample 13 | 900 | 150 | 8.0 | 1.5 | 1.0 | 25.0 | 64.5 | 90 |
| Invention Sample 14 | 900 | 180 | 8.5 | 1.2 | 1.5 | 20.0 | 68.8 | 80 |
| Invention Sample 15 | 900 | 120 | 8.0 | 1.8 | 1.0 | 20.0 | 69.2 | 90 |
| Invention Sample 16 | 900 | 150 | 8.0 | 1.8 | 0.5 | 20.0 | 69.7 | 100 |
| Invention Sample 17 | 900 | 150 | 8.0 | 1.5 | 1.0 | 20.0 | 69.5 | 90 |
| Invention Sample 18 | 900 | 120 | 9.0 | 1.5 | 1.0 | 20.0 | 68.5 | 90 |
| Invention Sample 19 | 920 | 150 | 8.0 | 1.5 | 0.5 | 20.0 | 70.0 | 90 |
| Invention Sample 20 | 920 | 150 | 8.5 | 1.5 | 1.0 | 20.0 | 69.0 | 90 |
| Invention Sample 21 | 900 | 150 | 8.0 | 1.5 | 1.0 | 20.0 | 69.5 | 90 |
| Invention Sample 22 | 900 | 150 | 8.0 | 1.5 | 1.5 | 20.0 | 69.0 | 90 |
| Invention Sample 23 | 880 | 150 | 9.0 | 1.5 | 1.0 | 20.0 | 68.5 | 90 |
| Invention Sample 24 | 900 | 150 | 8.0 | 1.5 | 0.5 | 20.0 | 70.0 | 90 |
| Invention Sample 25 | 900 | 150 | 8.5 | 1.5 | 1.0 | 20.0 | 69.0 | 90 |
| Invention Sample 26 | 880 | 180 | 8.0 | - | - | 20.0 | 72.0 | 100 |
| Invention Sample 27 | - | - | - | - | - | - | - | - |
| Invention Sample 28 | - | - | - | - | - | - | - | - |
| Invention Sample 29 | - | - | - | - | - | - | - | - |
| Comparative Sample 1 | 900 | 150 | 8.5 | 1.5 | 1.0 | 20.0 | 69.0 | 90 |
| Comparative Sample 2 | 900 | 150 | 8.0 | 1.5 | 5.0 | 20.0 | 65.5 | 90 |
| Comparative Sample 3 | 880 | 150 | 8.0 | 1.5 | 1.0 | 20.0 | 69.5 | 90 |
| Comparative Sample 4 | 900 | 180 | 9.0 | 1.5 | 1.0 | 20.0 | 68.5 | 90 |
| Comparative Sample 5 | 920 | 150 | 8.0 | 1.5 | 1.5 | 20.0 | 69.0 | 90 |
| Comparative Sample 6 | 900 | 150 | 8.5 | 1.5 | 1.0 | 5.0 | 84.0 | 90 |
| Comparative Sample 7 | 900 | 150 | 8.0 | 1.5 | 1.0 | 30.0 | 59.5 | 90 |
| Comparative Sample 8 | 920 | 180 | 9.0 | 1.5 | 1.5 | 40.0 | 48.0 | 90 |
| Comparative Sample 9 | 900 | 120 | 8.0 | 0.8 | 1.0 | 20.0 | 70.2 | 70 |
| Comparative Sample 10 | 900 | 180 | 8.0 | 2.4 | 1.0 | 20.0 | 68.6 | 100 |
| Comparative Sample 11 | 880 | 120 | 8.5 | 1.5 | 0.5 | 20.0 | 69.5 | 90 |
| Comparative Sample 12 | 900 | 150 | 8.0 | 1.5 | 1.0 | 20.0 | 69.5 | 90 |
| Comparative Sample 13 | 900 | 150 | 8.0 | 1.5 | 1.0 | 20.0 | 69.5 | 90 |
| Comparative Sample 14 | 900 | 150 | 8.0 | 1.5 | 1.0 | 20.0 | 69.5 | 90 |

**[Table 6]**

| Sample Number | Upper layer (Y layer) | Pressure (hPa) | Raw material composition (mol%) | CH₄ | CH₃CN | N₂ | H₂ | Gas flow rate (L/min) |
|---|---|---|---|---|---|---|---|---|
| | Temperature (°C) | | | | | | | |
| | | | TiCl₄ | | | | | |
| Invention Sample 1 | 880 | 150 | 8.5 | 1.5 | 0.8 | 20.0 | 69.2 | 90 |
| Invention Sample 2 | 900 | 150 | 8.0 | 1.5 | 0.8 | 20.0 | 69.7 | 90 |
| Invention Sample 3 | 900 | 150 | 8.0 | 1.5 | 0.8 | 20.0 | 69.7 | 90 |
| Invention Sample 4 | 880 | 150 | 8.0 | 1.5 | 0.8 | 20.0 | 69.7 | 90 |
| Invention Sample 5 | 900 | 180 | 8.5 | 1.5 | 0.8 | 20.0 | 69.2 | 90 |
| Invention Sample 6 | 900 | 150 | 8.0 | 1.5 | 0.8 | 20.0 | 69.7 | 90 |
| Invention Sample 7 | 900 | 150 | 8.0 | 1.5 | 0.8 | 20.0 | 69.7 | 90 |
| Invention Sample 8 | 920 | 150 | 9.0 | 1.5 | 0.8 | 20.0 | 68.7 | 90 |
| Invention Sample 9 | 900 | 150 | 8.0 | 1.5 | 0.8 | 20.0 | 69.7 | 90 |
| Invention Sample 10 | 900 | 150 | 8.0 | 1.5 | 0.8 | 20.0 | 69.7 | 90 |
| Invention Sample 11 | 900 | 120 | 9.0 | 1.5 | 0.8 | 10.0 | 78.7 | 90 |
| Invention Sample 12 | 880 | 150 | 8.0 | 1.5 | 0.8 | 25.0 | 64.7 | 90 |
| Invention Sample 13 | 900 | 150 | 8.0 | 1.5 | 0.8 | 25.0 | 64.7 | 90 |
| Invention Sample 14 | 900 | 180 | 8.5 | 1.2 | 0.8 | 20.0 | 69.5 | 80 |
| Invention Sample 15 | 900 | 120 | 8.0 | 1.8 | 0.8 | 20.0 | 69.4 | 90 |
| Invention Sample 16 | 900 | 150 | 8.0 | 1.8 | 0.8 | 20.0 | 69.4 | 100 |
| Invention Sample 17 | 900 | 150 | 8.0 | 1.5 | 0.8 | 20.0 | 69.7 | 90 |
| Invention Sample 18 | 900 | 120 | 9.0 | 1.5 | 0.8 | 20.0 | 68.7 | 90 |
| Invention Sample 19 | 920 | 150 | 8.0 | 1.5 | 0.8 | 20.0 | 69.7 | 90 |
| Invention Sample 20 | 920 | 150 | 8.5 | 1.5 | 0.8 | 20.0 | 69.2 | 90 |
| Invention Sample 21 | 900 | 150 | 8.0 | 1.5 | 0.8 | 20.0 | 69.7 | 90 |
| Invention Sample 22 | 900 | 150 | 8.0 | 1.5 | 0.8 | 20.0 | 69.7 | 90 |
| Invention Sample 23 | 880 | 150 | 9.0 | 1.5 | 0.8 | 20.0 | 68.7 | 90 |
| Invention Sample 24 | 900 | 150 | 8.0 | 1.5 | 0.8 | 20.0 | 69.7 | 90 |
| Invention Sample 25 | 900 | 150 | 8.5 | 1.5 | 0.8 | 20.0 | 69.2 | 90 |
| Invention Sample 26 | 880 | 180 | 8.0 | 0.3 | 0.8 | 20.0 | 70.9 | 100 |
| Invention Sample 27 | 900 | 120 | 9.0 | 1.5 | 0.8 | 20.0 | 68.7 | 90 |
| Invention Sample 28 | 900 | 120 | 9.0 | 1.5 | 0.8 | 20.0 | 68.7 | 90 |
| Invention Sample 29 | 900 | 120 | 9.0 | 1.5 | 0.8 | 20.0 | 68.7 | 90 |
| Comparative Sample 1 | 900 | 150 | 8.5 | 1.5 | 0.8 | 20.0 | 69.2 | 90 |
| Comparative Sample 2 | 900 | 150 | 8.0 | 1.5 | 0.8 | 20.0 | 69.7 | 90 |
| Comparative Sample 3 | 880 | 150 | 8.0 | 1.5 | 0.8 | 20.0 | 69.7 | 90 |
| Comparative Sample 4 | 900 | 180 | 9.0 | 1.5 | 0.8 | 20.0 | 68.7 | 90 |
| Comparative Sample 5 | 920 | 150 | 8.0 | 1.5 | 0.8 | 20.0 | 69.7 | 90 |
| Comparative Sample 6 | 900 | 150 | 8.5 | 1.5 | 0.8 | 5.0 | 84.2 | 90 |
| Comparative Sample 7 | 900 | 150 | 8.0 | 1.5 | 0.8 | 30.0 | 59.7 | 90 |
| Comparative Sample 8 | 920 | 180 | 9.0 | 1.5 | 0.8 | 40.0 | 48.7 | 90 |
| Comparative Sample 9 | 900 | 120 | 8.0 | 0.8 | 0.8 | 20.0 | 70.4 | 70 |
| Comparative Sample 10 | 900 | 180 | 8.0 | 2.4 | 0.8 | 20.0 | 68.8 | 100 |
| Comparative Sample 11 | 880 | 120 | 8.5 | 1.5 | 0.8 | 20.0 | 69.2 | 90 |
| Comparative Sample 12 | 900 | 150 | 8.0 | 1.5 | 0.8 | 20.0 | 69.7 | 90 |
| Comparative Sample 13 | 900 | 150 | 8.0 | 1.5 | 0.8 | 20.0 | 69.7 | 90 |
| Comparative Sample 14 | 900 | 150 | 8.0 | 1.5 | 0.8 | 20.0 | 69.7 | 90 |

**[Table 7]**

| Sample Number | Coating layer | Averag e thickn ess (µm) | Second layer | Averag e thickn ess (µm) | Third layer | Averag e thickn ess (µm) | Averag e thickn ess (µm) |
|---|---|---|---|---|---|---|---|
| | Lower layer | | | | | | |
| | First layer | | | | | | |
| | Compositi on | | Composi tion | | Composi tion | | |
| Invention Sample 1 | TiN | 0.2 | TiCN | 8.5 | TiCNO | 0.3 | 9.0 |
| Invention Sample 2 | TiN | 0.2 | TiCN | 3.0 | TiCNO | 0.3 | 3.5 |
| Invention Sample 3 | TiN | 0.2 | TiCN | 14.0 | TiCNO | 0.3 | 14.5 |
| Invention Sample 4 | TiN | 0.2 | TiCN | 12.5 | TiCNO | 0.3 | 13.0 |
| Invention Sample 5 | TiN | 0.2 | TiCN | 4.0 | TiCNO | 0.3 | 4.5 |
| Invention Sample 6 | TiN | 0.2 | TiCN | 8.5 | TiCNO | 0.3 | 9.0 |
| Invention Sample 7 | TiN | 0.2 | TiCN | 8.5 | TiCNO | 0.3 | 9.0 |
| Invention Sample 8 | TiN | 0.2 | TiCN | 8.5 | TiCNO | 0.3 | 9.0 |
| Invention Sample 9 | TiN | 0.2 | TiCN | 4.5 | TiCNO | 0.3 | 5.0 |
| Invention Sample 10 | TiN | 0.2 | TiCN | 12.0 | TiCNO | 0.3 | 12.5 |
| Invention Sample 11 | TiN | 0.2 | TiCN | 8.5 | TiCNO | 0.3 | 9.0 |
| Invention Sample 12 | TiN | 0.2 | TiCN | 8.5 | TiCNO | 0.3 | 9.0 |
| Invention Sample 13 | TiN | 0.2 | TiCN | 8.5 | TiCNO | 0.3 | 9.0 |
| Invention Sample 14 | TiN | 0.2 | TiCN | 8.5 | TiCNO | 0.3 | 9.0 |
| Invention Sample 15 | TiN | 0.2 | TiCN | 8.5 | TiCNO | 0.3 | 9.0 |
| Invention Sample 16 | TiN | 0.2 | TiCN | 8.5 | TiCNO | 0.3 | 9.0 |
| Invention Sample 17 | TiN | 0.2 | TiCN | 8.5 | TiCNO | 0.3 | 9.0 |
| Invention Sample 18 | TiN | 0.2 | TiCN | 8.5 | TiCNO | 0.3 | 9.0 |
| Invention Sample 19 | TiC | 0.2 | TiCN | 8.5 | TiCNO | 0.3 | 9.0 |
| Invention Sample 20 | TiN | 0.1 | TiCN | 8.5 | TiCNO | 0.3 | 8.9 |
| Invention Sample 21 | TiN | 0.5 | TiCN | 8.5 | TiCNO | 0.3 | 9.3 |
| Invention Sample 22 | TiN | 0.2 | TiCN | 8.5 | TiCO | 0.3 | 9.0 |
| Invention Sample 23 | TiN | 0.2 | TiCN | 8.5 | TiCNO | 0.1 | 8.8 |
| Invention Sample 24 | TiN | 0.2 | TiCN | 8.5 | TiCNO | 1.0 | 9.7 |
| Invention Sample 25 | TiN | 0.2 | TiCN | 8.5 | TiCNO | 0.3 | 9.0 |
| Invention Sample 26 | TiN | 0.2 | TiCN | 8.5 | TiCNO | 0.3 | 9.0 |
| Invention Sample 27 | TiN | 0.2 | TiCN | 5.0 | TiCNO | 0.3 | 5.5 |
| Invention Sample 28 | TiN | 0.2 | TiCN | 11.5 | TiCNO | 0.3 | 12.0 |
| Invention Sample 29 | TiN | 0.2 | TiCN | 8.5 | TiCNO | 0.3 | 9.0 |
| Comparative Sample 1 | TiN | 0.2 | TiCN | 15.5 | TiCNO | 0.3 | 16.0 |
| Comparative Sample 2 | TiN | 0.2 | TiCN | 4.0 | TiCNO | 0.3 | 4.5 |
| Comparative Sample 3 | TiN | 0.2 | TiCN | 8.5 | TiCNO | 0.3 | 9.0 |
| Comparative Sample 4 | TiN | 0.2 | TiCN | 3.0 | TiCNO | 0.3 | 3.5 |
| Comparative Sample 5 | TiN | 0.2 | TiCN | 15.0 | TiCNO | 0.3 | 15.5 |
| Comparative Sample 6 | TiN | 0.2 | TiCN | 8.5 | TiCNO | 0.3 | 9.0 |
| Comparative Sample 7 | TiN | 0.2 | TiCN | 8.5 | TiCNO | 0.3 | 9.0 |
| Comparative Sample 8 | TiN | 0.2 | TiCN | 8.5 | TiCNO | 0.3 | 9.0 |
| Comparative Sample 9 | TiN | 0.2 | TiCN | 8.5 | TiCNO | 0.3 | 9.0 |
| Comparative Sample 10 | TiN | 0.2 | TiCN | 8.5 | TiCNO | 0.3 | 9.0 |
| Comparative Sample 11 | TiN | 0.2 | TiCN | 8.5 | TiCNO | 0.3 | 9.0 |
| Comparative Sample 12 | TiN | 0.2 | TiCN | 8.5 | TiCNO | 0.3 | 9.0 |
| Comparative Sample 13 | TiN | 0.2 | TiCN | 8.5 | TiCNO | 0.3 | 9.0 |
| Comparative Sample 14 | TiN | 0.2 | TiCN | 8.5 | TiCNO | 0.3 | 9.0 |

**[Table 8]**

| Sample Number | Coating layer | | |
|---|---|---|---|
| | Intermediate layer | | |
| | Crystal system | Composition | Average thickness (µm) |
| Invention Sample 1 | α | Al₂O₃ | 8.5 |
| Invention Sample 2 | α | Al₂O₃ | 8.5 |
| Invention Sample 3 | α | Al₂O₃ | 7.5 |
| Invention Sample 4 | α | Al₂O₃ | 3.5 |
| Invention Sample 5 | α | Al₂O₃ | 14.0 |
| Invention Sample 6 | α | Al₂O₃ | 8.5 |
| Invention Sample 7 | α | Al₂O₃ | 8.5 |
| Invention Sample 8 | α | Al₂O₃ | 8.5 |
| Invention Sample 9 | α | Al₂O₃ | 5.0 |
| Invention Sample 10 | α | Al₂O₃ | 11.0 |
| Invention Sample 11 | α | Al₂O₃ | 8.5 |
| Invention Sample 12 | α | Al₂O₃ | 8.5 |
| Invention Sample 13 | α | Al₂O₃ | 8.5 |
| Invention Sample 14 | α | Al₂O₃ | 8.5 |
| Invention Sample 15 | α | Al₂O₃ | 8.5 |
| Invention Sample 16 | α | Al₂O₃ | 8.5 |
| Invention Sample 17 | α | Al₂O₃ | 8.5 |
| Invention Sample 18 | α | Al₂O₃ | 8.5 |
| Invention Sample 19 | α | Al₂O₃ | 8.5 |
| Invention Sample 20 | α | Al₂O₃ | 8.5 |
| Invention Sample 21 | α | Al₂O₃ | 8.5 |
| Invention Sample 22 | α | Al₂O₃ | 8.5 |
| Invention Sample 23 | α | Al₂O₃ | 8.5 |
| Invention Sample 24 | α | Al₂O₃ | 8.5 |
| Invention Sample 25 | α | Al₂O₃ | 8.5 |
| Invention Sample 26 | α | Al₂O₃ | 8.5 |
| Invention Sample 27 | α | Al₂O₃ | 5.5 |
| Invention Sample 28 | α | Al₂O₃ | 10.0 |
| Invention Sample 29 | α | Al₂O₃ | 8.5 |
| Comparative Sample 1 | α | Al₂O₃ | 7.5 |
| Comparative Sample 2 | α | Al₂O₃ | 16.0 |
| Comparative Sample 3 | α | Al₂O₃ | 8.5 |
| Comparative Sample 4 | α | Al₂O₃ | 2.5 |
| Comparative Sample 5 | α | Al₂O₃ | 13.0 |
| Comparative Sample 6 | α | Al₂O₃ | 8.5 |
| Comparative Sample 7 | α | Al₂O₃ | 8.5 |
| Comparative Sample 8 | α | Al₂O₃ | 8.5 |
| Comparative Sample 9 | α | Al₂O₃ | 8.5 |
| Comparative Sample 10 | α | Al₂O₃ | 8.5 |
| Comparative Sample 11 | α | Al₂O₃ | 8.5 |
| Comparative Sample 12 | α | Al₂O₃ | 8.5 |
| Comparative Sample 13 | α | Al₂O₃ | 8.5 |
| Comparative Sample 14 | α | Al₂O₃ | 8.5 |

**[Table 9]**

| Sample Number | Coating layer | | | | | | | |
|---|---|---|---|---|---|---|---|---|
| | Upper layer | | | | | | | Total avera ge thick ness (µm) |
| | X layer | | Y layer | | Z laver | | Avera ge thick ness (µm) | |
| | Composi tion | Avera ge thick ness (µm) | Composi tion | Avera ge thick ness (µm) | Composi tion | Avera ge thick ness (µm) | | |
| Invention Sample 1 | TiCNO | 0.5 | TiCN | 3.5 | TiN | 0.2 | 4.2 | 21.7 |
| Invention Sample 2 | TiCNO | 0.5 | TiCN | 3.5 | TiN | 0.2 | 4.2 | 16.2 |
| Invention Sample 3 | TiCNO | 0.5 | TiCN | 3.5 | TiN | 0.2 | 4.2 | 26.2 |
| Invention Sample 4 | TiCNO | 0.5 | TiCN | 3.5 | TiN | 0.2 | 4.2 | 20.7 |
| Invention Sample 5 | TiCNO | 0.5 | TiCN | 3.5 | TiN | 0.2 | 4.2 | 22.7 |
| Invention Sample 6 | TiCNO | 0.3 | TiCN | 0.8 | TiN | 0.1 | 1.2 | 18.7 |
| Invention Sample 7 | TiCNO | 0.3 | TiCN | 1.2 | - | - | 1.5 | 19.0 |
| Invention Sample 8 | TiCNO | 0.5 | TiCN | 5.0 | TiN | 0.5 | 6.0 | 23.5 |
| Invention Sample 9 | TiCNO | 0.5 | TiCN | 2.5 | - | - | 3.0 | 13.0 |
| Invention Sample 10 | TiCNO | 0.5 | TiCN | 4.5 | TiN | 0.2 | 5.2 | 28.7 |
| Invention Sample 11 | TiCNO | 0.5 | TiCN | 3.5 | TiN | 0.2 | 4.2 | 21.7 |
| Invention Sample 12 | TiCNO | 0.5 | TiCN | 3.5 | TiN | 0.2 | 4.2 | 21.7 |
| Invention Sample 13 | TiCNO | 0.5 | TiCN | 3.5 | TiN | 0.2 | 4.2 | 21.7 |
| Invention Sample 14 | TiCNO | 0.5 | TiCN | 3.5 | TiN | 0.2 | 4.2 | 21.7 |
| Invention Sample 15 | TiCNO | 0.5 | TiCN | 3.5 | TiN | 0.2 | 4.2 | 21.7 |
| Invention Sample 16 | TiCNO | 0.5 | TiCN | 3.5 | TiN | 0.2 | 4.2 | 21.7 |
| Invention Sample 17 | TiCNO | 0.5 | TiCN | 3.5 | TiN | 0.2 | 4.2 | 21.7 |
| Invention Sample 18 | TiCNO | 0.5 | TiCN | 3.5 | TiN | 0.2 | 4.2 | 21.7 |
| Invention Sample 19 | TiCNO | 0.5 | TiCN | 3.5 | TiN | 0.2 | 4.2 | 21.7 |
| Invention Sample 20 | TiCNO | 0.5 | TiCN | 3.5 | TiN | 0.2 | 4.2 | 21.6 |
| Invention Sample 21 | TiCNO | 0.5 | TiCN | 3.5 | TiN | 0.2 | 4.2 | 22.0 |
| Invention Sample 22 | TiCNO | 0.5 | TiCN | 3.5 | TiN | 0.2 | 4.2 | 21.7 |
| Invention Sample 23 | TiCNO | 0.5 | TiCN | 3.5 | TiN | 0.2 | 4.2 | 21.5 |
| Invention Sample 24 | TiCNO | 0.5 | TiCN | 3.5 | TiN | 0.2 | 4.2 | 22.4 |
| Invention Sample 25 | TiCNO | 0.3 | TiCN | 3.7 | - | - | 4.0 | 21.5 |
| Invention Sample 26 | TiN | 0.3 | TiCN | 3.7 | TiN | 0.2 | 4.2 | 21.7 |
| Invention Sample 27 | - | - | TiCN | 3.0 | - | - | 3.0 | 14.0 |
| Invention Sample 28 | - | - | TiCN | 4.0 | - | - | 4.0 | 26.0 |
| Invention Sample 29 | - | - | TiCN | 4.0 | - | - | 4.0 | 21.5 |
| Comparative Sample 1 | TiCNO | 0.5 | TiCN | 3.5 | TiN | 0.2 | 4.2 | 27.7 |
| Comparative Sample 2 | TiCNO | 0.5 | TiCN | 3.5 | TiN | 0.2 | 4.2 | 24.7 |
| Comparative Sample 3 | TiCNO | 0.5 | TiCN | 7.0 | TiN | 0.5 | 8.0 | 25.5 |
| Comparative Sample 4 | TiCNO | 0.5 | TiCN | 2.0 | - | - | 2.5 | 8.5 |
| Comparative Sample 5 | TiCNO | 0.5 | TiCN | 4.5 | TiN | 0.2 | 5.2 | 33.7 |
| Comparative Sample 6 | TiCNO | 0.5 | TiCN | 3.5 | TiN | 0.2 | 4.2 | 21.7 |
| Comparative Sample 7 | TiCNO | 0.5 | TiCN | 3.5 | TiN | 0.2 | 4.2 | 21.7 |
| Comparative Sample 8 | TiCNO | 0.5 | TiCN | 3.5 | TiN | 0.2 | 4.2 | 21.7 |
| Comparative Sample 9 | TiCNO | 0.5 | TiCN | 3.5 | TiN | 0.2 | 4.2 | 21.7 |
| Comparative Sample 10 | TiCNO | 0.5 | TiCN | 3.5 | TiN | 0.2 | 4.2 | 21.7 |
| Comparative Sample 11 | TiCNO | 0.5 | TiCN | 3.5 | TiN | 0.2 | 4.2 | 21.7 |
| Comparative Sample 12 | TiCNO | 0.5 | TiCN | 3.5 | TiN | 0.2 | 4.2 | 21.7 |
| Comparative Sample 13 | TiCNO | 0.5 | TiCN | 3.5 | TiN | 0.2 | 4.2 | 21.7 |
| Comparative Sample 14 | TiCNO | 0.5 | TiCN | 3.5 | TiN | 0.2 | 4.2 | 21.7 |

### RSA

The RSA of the samples obtained was calculated as follows.

In the obtained samples, the cross section of the TiCN layer of the upper layer was exposed in a direction parallel to the surface of the substrate, in a position where 30% or more and 90% or less of the average thickness of the TiCN layer in the upper layer remained from the substrate side. The obtained cross section was subjected to mirror polishing, and the mirror polished surface was observed by a field emission type scanning electron microscope (FE-SEM). By using an electron backscatter diffraction pattern apparatus (EBSD) incorporated in FE-SEM, the misorientation A was measured. The sum of areas of an entire cross section of the TiCN layer in the upper layer measured was taken as 100 area%. The ratio of the sum of cross-sectional areas of the region having a misorientation A of 0 degrees or more and less than 15 degrees (hereinafter also referred to as region A) was defined as RSA (unit: area %). Specifically, the cross-sectional area of the region A and the cross-sectional area of the region having a misorientation A of 0 degrees or more and 45 degrees or less were first determined. The sum of cross-sectional areas of the region having a misorientation of 0 degrees or more and 45 degrees or less was 100 area%. The ratio of the sum of cross-sectional areas of the region A to the sum of cross-sectional areas of the region having a misorientation A of 0 degrees or more and 45 degrees or less was defined as RSA. The above measurement results are shown in the following Table 10. The measurement by EBSD was performed as follows. The sample was set in the FE-SEM. The sample was irradiated with an electron beam with an acceleration voltage of 15 kV and an irradiation current of 1.0 nA at an incident angle of 70 degrees. In the measurement range of 120 µm × 120 µm, the misorientation A and cross-sectional area of each grain were measured by setting the EBSD to a step size (distance between measurement points) of 0.1 µm. The cross-sectional area of the TiCN layer of the upper layer within the measurement range was taken as the total of pixels corresponding to the area. That is, the sum of the cross-sectional areas of each region based on the misorientation A was determined by summing up the pixels occupied by the cross section of the region corresponding to the range of the misorientation A and converting the sum to the area. The same measurement by EBSD was performed in the above measurement range at three fields of view in total, and the average values of the obtained areas were determined. The RSA was calculated from the obtained average values. The results are shown in Table 10.

### Grain Boundary Length

The total length of Σ3 grain boundaries to 100% of the total grain boundary length in the entire cross section of the TiCN layer in the upper layer of the samples obtained, as well as that in the region A, was measured as follows. In the obtained samples, the cross section of the TiCN layer of the upper layer was exposed in a direction parallel to the surface of the substrate, in a position where 30% or more and 90% or less of the average thickness of the TiCN layer in the upper layer remained from the substrate side. The resulting cross section was mirror-polished with colloidal silica to prepare a mirror-polished observation surface. Subsequently, the observation surface was observed using a field emission scanning electron microscope (FE-SEM) equipped with EBSD. The rake face was selected as the observation region. Measurement by EBSD was carried out as follows. The sample was set in the FE-SEM, and was irradiated with an electron beam at an incident angle of 70°, under an accelerating voltage of 15 kV and a beam current of 1.0 nA. EBSD analysis was performed with a measurement range of 120 µm × 120 µm and a step size (distance between measurement points) of 0.1 µm, by analyzing the crystal orientation of individual grains in the TiCN layer in the upper layer. At this stage, boundaries between adjacent measurement points with a difference in crystal orientation of 5° or more were defined as grain boundaries.

Data processing was performed using commercially available software. The ratio of the total length of Σ3 grain boundaries to 100% of the total grain boundary length was determined by counting the CSL grain boundaries corresponding to any Σ value and expressing them as a ratio to all grain boundaries. Accordingly, the total length of Σ3 grain boundaries to 100% of the total grain boundary length in the entire cross section and the region A of the TiCN layer in the upper layer was determined. Within the measurement range on the above-mentioned observation surface, three fields of view were analyzed in total, and the average value of each measurement was determined. From the obtained average values, the ratio of the total length of Σ3 grain boundaries to 100% of the total grain boundary length in the entire cross section of the TiCN layer in the upper layer, as well as that in the region A of the TiCN layer in the upper layer, were calculated (hereinafter also referred to as Σ3/ total grain boundaries(%)). The results are shown in Table 10.

**[Table 10]**

| Sample Number | Upper layer | | |
|---|---|---|---|
| | Entire cross section | Region A | RSA (Area%) |
| | Σ3/ total grain boundaries (%) | Σ3/ total grain boundaries (%) | |
| Invention Sample 1 | 16 | 43 | 48 |
| Invention Sample 2 | 16 | 44 | 49 |
| Invention Sample 3 | 16 | 43 | 50 |
| Invention Sample 4 | 16 | 43 | 50 |
| Invention Sample 5 | 17 | 42 | 52 |
| Invention Sample 6 | 16 | 41 | 49 |
| Invention Sample 7 | 15 | 42 | 48 |
| Invention Sample 8 | 16 | 46 | 50 |
| Invention Sample 9 | 16 | 41 | 50 |
| Invention Sample 10 | 15 | 44 | 49 |
| Invention Sample 11 | 8 | 31 | 48 |
| Invention Sample 12 | 21 | 51 | 50 |
| Invention Sample 13 | 24 | 57 | 51 |
| Invention Sample 14 | 15 | 41 | 31 |
| Invention Sample 15 | 18 | 43 | 62 |
| Invention Sample 16 | 25 | 46 | 68 |
| Invention Sample 17 | 15 | 33 | 48 |
| Invention Sample 18 | 17 | 53 | 52 |
| Invention Sample 19 | 15 | 43 | 50 |
| Invention Sample 20 | 15 | 43 | 51 |
| Invention Sample 21 | 15 | 43 | 50 |
| Invention Sample 22 | 14 | 43 | 52 |
| Invention Sample 23 | 15 | 43 | 50 |
| Invention Sample 24 | 15 | 43 | 49 |
| Invention Sample 25 | 15 | 43 | 50 |
| Invention Sample 26 | 18 | 42 | 34 |
| Invention Sample 27 | 13 | 43 | 43 |
| Invention Sample 28 | 14 | 44 | 46 |
| Invention Sample 29 | 14 | 43 | 45 |
| Comparative Sample 1 | 15 | 44 | 51 |
| Comparative Sample 2 | 16 | 43 | 50 |
| Comparative Sample 3 | 16 | 47 | 51 |
| Comparative Sample 4 | 17 | 41 | 52 |
| Comparative Sample 5 | 16 | 45 | 50 |
| Comparative Sample 6 | 5 | 22 | 47 |
| Comparative Sample 7 | 29 | 64 | 52 |
| Comparative Sample 8 | 33 | 66 | 52 |
| Comparative Sample 9 | 13 | 43 | 21 |
| Comparative Sample 10 | 27 | 47 | 74 |
| Comparative Sample 11 | 13 | 28 | 46 |
| Comparative Sample 12 | 14 | 24 | 43 |
| Comparative Sample 13 | 13 | 25 | 42 |
| Comparative Sample 14 | 18 | 61 | 53 |

### RSm

The mean spacing of profile irregularities RSm on the surface of the intermediate layer of the obtained samples was measured as follows.

Each sample obtained was immersed in a mixed solution of hydrofluoric acid and nitric acid for about 20 minutes to remove the upper layer, thereby exposing the surface of the intermediate layer. The surface texture of the exposed intermediate layer was measured using a laser surface roughness tester (VK-X100, manufactured by Keyence Corporation) under the following conditions. The results are shown in Table 11 below.
Standard: JIS B0601:2001 (ISO 4287:1997)
Reference length at measurement: 50 µm
Number of measurement lines: 10 lines at intervals of 10 µm

**[Table 11]**

| Sample Number | Intermediate layer |
|---|---|
| | RSm (µm) |
| Invention Sample 1 | 11 |
| Invention Sample 2 | 10 |
| Invention Sample 3 | 12 |
| Invention Sample 4 | 12 |
| Invention Sample 5 | 10 |
| Invention Sample 6 | 11 |
| Invention Sample 7 | 11 |
| Invention Sample 8 | 11 |
| Invention Sample 9 | 11 |
| Invention Sample 10 | 10 |
| Invention Sample 11 | 7 |
| Invention Sample 12 | 11 |
| Invention Sample 13 | 16 |
| Invention Sample 14 | 11 |
| Invention Sample 15 | 11 |
| Invention Sample 16 | 11 |
| Invention Sample 17 | 6 |
| Invention Sample 18 | 18 |
| Invention Sample 19 | 11 |
| Invention Sample 20 | 11 |
| Invention Sample 21 | 11 |
| Invention Sample 22 | 11 |
| Invention Sample 23 | 11 |
| Invention Sample 24 | 11 |
| Invention Sample 25 | 11 |
| Invention Sample 26 | 11 |
| Invention Sample 27 | 9 |
| Invention Sample 28 | 10 |
| Invention Sample 29 | 9 |
| Comparative Sample 1 | 12 |
| Comparative Sample 2 | 10 |
| Comparative Sample 3 | 11 |
| Comparative Sample 4 | 13 |
| Comparative Sample 5 | 9 |
| Comparative Sample 6 | 6 |
| Comparative Sample 7 | 16 |
| Comparative Sample 8 | 12 |
| Comparative Sample 9 | 11 |
| Comparative Sample 10 | 11 |
| Comparative Sample 11 | 4 |
| Comparative Sample 12 | 3 |
| Comparative Sample 13 | 3 |
| Comparative Sample 14 | 22 |

Cutting tests 1 and 2 were conducted using the obtained samples, i.e., Invention Samples 1 to 29 and Comparative Samples 1 to 14, under the following conditions. Cutting test 1 is a test for evaluating wear resistance, and cutting test 2 is a test for evaluating fracture resistance. The results of the respective cutting tests are shown in Table 10.

### [Cutting test 1]

Workpiece material: SCM440,
Workpiece material shape: round bar,
Cutting speed: 250 m/min,
Depth of cut: 1.5 mm,
Feed: 0.25 mm/rev,
Coolant: none,
Evaluation item: the time at which the sample was fractured or the maximum flank wear width reached 0.3 mm was defined as the tool life, and the machining time to reach the end of the tool life was measured.

### [Cutting test 2]

Workpiece material: SCM415,
Workpiece material shape: round bar with four grooves at an equal distance on the outer peripheral surface,
Cutting speed: 220 m/min,
Depth of cut: 1.5 mm,
Feed: 0.35 mm/rev,
Coolant: water-soluble coolant,
Evaluation item: the time at which the sample was fractured was defined as the tool life, and the number of shocks to reach the end of the tool life was measured.

As to the machining time to reach the end of the tool life in cutting test 1, evaluations were made with grade "A" for 21 minutes or more, grade "B" for 15 minutes or more and less than 21 minutes, and "C" for less than 15 minutes. As to the cumulative number of shocks to reach the end of the tool life in cutting test 2, evaluations were made with grade "A" for 12,000 shocks or more, grade "B" for 8,000 shocks or more and less than 12,000 shocks, and grade "C" for less than 8,000. In such evaluations, "A" refers to excellent, "B" refers to good and "C" refers to inferior, meaning that a sample involving a larger number of "A"s or "B"s has more excellent cutting performance. The evaluation results are shown in Table 12.

**[Table 12]**

| Sample Number | Cutting test 1 | | Cutting test 2 | |
|---|---|---|---|---|
| | Tool life (minute) | Evaluation | Tool life (number of shocks) | Evaluation |
| Invention Sample 1 | 20 | B | 12500 | A |
| Invention Sample 2 | 16 | B | 13000 | A |
| Invention Sample 3 | 21 | A | 9500 | B |
| Invention Sample 4 | 18 | B | 12500 | A |
| Invention Sample 5 | 19 | B | 11500 | B |
| Invention Sample 6 | 17 | B | 12500 | A |
| Invention Sample 7 | 18 | B | 13000 | A |
| Invention Sample 8 | 20 | B | 11500 | B |
| Invention Sample 9 | 15 | B | 13500 | A |
| Invention Sample 10 | 23 | A | 8500 | B |
| Invention Sample 11 | 17 | B | 10500 | B |
| Invention Sample 12 | 21 | A | 11500 | B |
| Invention Sample 13 | 22 | A | 9500 | B |
| Invention Sample 14 | 20 | B | 9500 | B |
| Invention Sample 15 | 19 | B | 13500 | A |
| Invention Sample 16 | 17 | B | 12500 | A |
| Invention Sample 17 | 15 | B | 11000 | B |
| Invention Sample 18 | 23 | A | 10000 | B |
| Invention Sample 19 | 20 | B | 11500 | B |
| Invention Sample 20 | 20 | B | 12000 | A |
| Invention Sample 21 | 19 | B | 12500 | A |
| Invention Sample 22 | 19 | B | 11500 | B |
| Invention Sample 23 | 19 | B | 12000 | A |
| Invention Sample 24 | 20 | B | 13000 | A |
| Invention Sample 25 | 20 | B | 12500 | A |
| Invention Sample 26 | 19 | B | 10000 | B |
| Invention Sample 27 | 16 | B | 13000 | A |
| Invention Sample 28 | 22 | A | 9000 | B |
| Invention Sample 29 | 20 | B | 11500 | B |
| Comparative Sample 1 | 20 | B | 3500 | C |
| Comparative Sample 2 | 18 | B | 6000 | C |
| Comparative Sample 3 | 19 | B | 5000 | C |
| Comparative Sample 4 | 9 | C | 13500 | A |
| Comparative Sample 5 | 15 | B | 1500 | C |
| Comparative Sample 6 | 11 | C | 6000 | C |
| Comparative Sample 7 | 22 | A | 5500 | C |
| Comparative Sample 8 | 22 | A | 4000 | C |
| Comparative Sample 9 | 21 | A | 4000 | C |
| Comparative Sample 10 | 13 | C | 10000 | B |
| Comparative Sample 11 | 11 | C | 6500 | C |
| Comparative Sample 12 | 10 | C | 6000 | C |
| Comparative Sample 13 | 10 | C | 6000 | C |
| Comparative Sample 14 | 22 | A | 4000 | C |

The results in Table 12 show that each invention sample had grade "A" or "B" in both cutting test 1 and cutting test 2. Meanwhile, as to the evaluations made on the comparative samples, each comparative sample had grade "C" in either or both of cutting test 1 and cutting test 2. Accordingly, it is apparent that the wear resistance and the fracture resistance of each invention sample are more excellent than that of each comparative sample.

It is apparent from the above results that each invention sample has excellent wear resistance and fracture resistance, thereby resulting in a longer tool life.

### Industrial Applicability

The coated cutting tool according to the present invention has excellent wear resistance and fracture resistance, so that the tool life can be extended more than that involved in the prior art, and from such perspective, the coated cutting tool has industrial applicability.

### Reference Signs List

1: Substrate, 2: Lower layer, 3: Intermediate layer, 4: Upper layer, 5: Coating layer, 6: Coated cutting tool.

## Claims

1. A coated cutting tool comprising a substrate and a coating layer formed on a surface of the substrate, wherein:
the coating layer comprises a lower layer, an intermediate layer, and an upper layer in this order from the substrate side to the surface side of the coating layer;
the lower layer comprises one or more Ti compound layers containing a Ti compound of Ti and an element of at least one kind selected from the group consisting of C, N, O and B;
an average thickness of the lower layer is 3.0 µm or more and 15.0 µm or less;
the intermediate layer comprises an α-Al₂O₃ layer containing α-aluminum oxide;
an average thickness of the intermediate layer is 3.0 µm or more and 15.0 µm or less;
the upper layer comprises one or more Ti compound layers containing a Ti compound of Ti and an element of at least one kind selected from the group consisting of C, N, O and B;
the upper layer comprises at least one TiCN layer containing TiCN;
an average thickness of the upper layer is 1.0 µm or more and 6.0 µm or less; and
in a cross section of the TiCN layer of the upper layer in a direction parallel to the surface of the substrate, when a sum of areas of an entire cross section is taken as 100 area%, a ratio of a sum of cross-sectional areas of regions A where a misorientation is 0 degrees or more and less than 15 degrees, the misorientation being an angle formed by a normal to the cross section of the TiCN layer of the upper layer and a normal to a (220) plane of grains of the TiCN layer, is 30 area% or more and 70 area% or less; and
in the region A, a ratio of the total length of Σ3 grain boundaries to 100% of the total grain boundary length, is 30% or more and less than 60%.

2. The coated cutting tool according to claim 1, wherein the ratio of the total length of Σ3 grain boundaries to 100% of the total grain boundary length in the entire cross section of the TiCN layer in the upper layer is less than 30%.

3. The coated cutting tool according to claim 1 or 2, wherein the surface of the intermediate layer has a mean spacing of profile irregularities RSm of 5 µm or more and 20 µm or less.

4. The coated cutting tool according to any one of claims 1 to 3, wherein the average thickness of the entire coating layer is 10.0 µm or more and 30.0 µm or less.
